# EUROPÄISCHE PATENTANMELDUNG

(11) **EP 3 222 671 A1**
(43) Veröffentlichungstag der Anmeldung: **27.09.2017**
(21) Anmeldenummer: 16161849.1
(22) Anmeldetag: 23.03.2016
(51) Int. Cl.: C09B 45/18, C09B 45/22, C09B 67/04, C09B 67/48, C09B 67/22

(54) **METALLAZOPIGMENTE**

(71) Anmelder: LANXESS Deutschland GmbH, 50569 Köln (DE)
(72) Erfinder: Borst, Hans-Ulrich, 50189 Elsdorf (DE); Linke, Frank, 51069 Köln (DE); ENDERT, Sabine, 42327 Wuppertal (DE)

(57) **Zusammenfassung**

Die neuen gelben Metallazopigmente auf Basis mindestens dreier Metallazoverbindungen, die sich mindestens in der Art des Metalls voneinander unterscheiden, besitzen verbesserte Farbstärken und eignen sich hervorragend zur Pigmentierung von Pigmentpräparationen für ein breites Anwendungsgebiet.

## Beschreibung

Die vorliegende Erfindung betrifft neue gelbe Metallazopigmente auf Basis mindestens dreier Metallazoverbindungen die sich mindestens in der Art des Metalls voneinander unterscheiden, Verfahren zu deren Herstellung und deren Verwendung als Gelbpigment in Pigmentpräparationen

Die Herstellung von Metallkomplexen aus Azobarbitursäure mit Nickelsalzen und deren Verwendung als gelbe Pigmente ist lange bekannt und vielfach in der Literatur beschrieben (vgl. z.B. W. Herbst, K. Hunger: Industrial Organic Pigments, 3. Auflage 2004, S. 390/397). Es ist weiterhin bekannt, dass diese Produkte weiter umgesetzt werden können, z.B. mit Melamin oder Melaminderivaten, um die anwendungstechnischen Eigenschaften der Pigmente beispielsweise bei der Einfärbung von Kunststoffen, Lacken und Farbfiltern für LCDs zu verbessern.

Des Weiteren ist in der Literatur beschrieben, dass zur Anpassung coloristischer Eigenschaften außer Nickelsalzen auch ein oder mehrere Salze unterschiedlicher Metalle mitverwendet werden können. Die Anmeldung EP-A 1 591 489 beschreibt Metallkomplexe von Azoverbindungen, die als Metalle solche aus der Reihe der Alkalimetalle, Erdalkalimetalle, der Lanthanoiden sowie Aluminium, Scandium, Titan, Vanadium, Chrom, Mangan, Kobalt, Kupfer, Nickel und Zink und gegebenenfalls Eisen enthalten. Die erhaltenen Pigmente weisen einen unterschiedlichen Farbort auf im Vergleich zu den reinen Nickel-Azobarbitursäurekomplexen.

Durch eine gezielte Oberflächenbelegung der Metallazopigment kann ebenfalls eine Verbesserung anwendungsbezogener Eigenschaften erzielt werden, speziell die Erniedrigung der Dispergierhärte als einem Maß für die Disperiereigenschaften des Pigments. Mit diesem Verfahren zur Verbesserung der Dispergierbarkeit ist jedoch eine Reduzierung der Farbstärke des Pigments verbunden, die in direkter Abhängigkeit von der Konzentration an Belegungsmittel steht.

Eine weitere Möglichkeit der Anpassung anwendungsbezogener Eigenschaften ist es die aus Nickel-Azobarbitursäurekomplexe mit z.B. Melamin hergestellten Pigmente zu tempern. Mit diesem Verfahrensschritt ist eine gezielte Änderung der Teilchengröße der Pigmente und deren spezifischer Oberfläche verbunden. Dieses Verfahren ist z.B. in EP-A 0 994 162 beschrieben.

Aus der EP-A 2682434 sind ebenfalls Metallazopigmente auf Basis von Nickel- und Zink-Azobarbitursäure und Melamin bekannt, die als Gelbkomponente in Farbfiltern eingesetzt werden können und über verbesserte coloristische Eigenschaften verfügen.

Die aus dem Stand der Technik bekannten Metallazopigmente sind jedoch hinsichtlich ihrer anwendungstechnischen Merkmale noch weiter verbesserungsbedürftig.

Es wurde gefunden, dass Metallazopigmente auf Basis von Azobarbitursäure, Zink- und Nickelsalzen und Melamin und/oder Melaminderivaten und mindestens einem weiteren, von Zink- und Nickelsalzen unterschiedlichen Metallsalz, überraschender Weise eine verbesserte Farbstärke aufweisen. Die Verbesserung dieser Eigenschaften ermöglichen den verbesserten Einsatz dieser Produkte u.a. zur Kunststoff- und Lackeinfärbung, zur Verwendung im InkJet und als Komponente von Farbfiltern für LCDs.

Die Erfindung betrifft daher Metallazopigmente, dadurch gekennzeichnet, dass sie enthalten die Komponenten
a) mindestens drei Metallazoverbindungen die sich mindestens in der Art des Metalls voneinander unterscheiden und die jeweils
   - Struktureinheiten der Formel (I), oder deren tautomeren Formen, 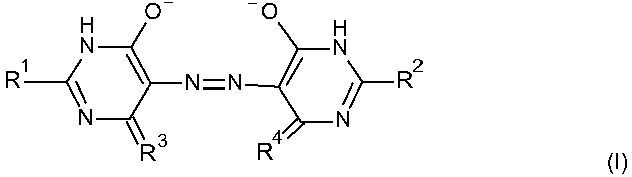 worin
      R¹ und R² unabhängig voneinander für OH, NH₂ oder NHR⁵ stehen,
      R³ und R⁴ unabhängig voneinander für =O oder =NR⁵ stehen,
      R⁵ für Wasserstoff oder Alkyl, vorzugsweise C₁-C₄-Alkyl, steht, und
   - Ni²⁺- beziehungsweise Zn²⁺-Ionen und mindestens ein weiteres Metallion Me enthalten,
   wobei
   Me für ein 2- oder 3- wertiges Metallion ausgewählt aus der Reihe La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Er³⁺, Tm³⁺ , Yb²⁺, Yb³⁺ , Mg²⁺, Ca²⁺, Sr²⁺, Ba²⁺, Sc³⁺, Y³⁺, Ti²⁺, Ti³⁺, Zr²⁺, Zr³⁺, V²⁺, V³⁺, Nb³⁺, Cr³⁺, Mo²⁺, Mo³⁺, Mn²⁺, Cd²⁺ und Pb²⁺ steht,
   mit der Maßgabe, dass die Menge an Zn²⁺-und Ni²⁺-Ionen zusammen 75 bis 99,5 Mol-% beträgt und die Menge an Metallionen Me 25 bis 0,5 Mol-% beträgt, jeweils bezogen auf ein Mol aller Metallionen im Metallazopigment
   und
   wobei das Molverhältnis von 90 : 3 bis 3 : 90, bevorzugt 80 : 5 bis 5: 80 und besonders bevorzugt 60 : 33 bis 33 : 60 beträgt,
   und
b) mindestens eine Verbindung der Formel (II) 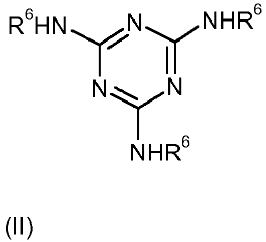 worin
   R⁶ für Wasserstoff oder Alkyl, vorzugsweise C₁-C₄-Alkyl das gegebenenfalls ein-oder mehrfach durch OH substituiert ist,
   steht.

Vorzugsweise stehen in Formel (I) R¹ und R² unabhängig voneinander für OH, NH₂ oder für einen Rest NHR⁵, wobei R⁵ für Wasserstoff oder C₁-C₄-Alkyl, steht.

Vorzugsweise stehen in Formel (I) R³ und R⁴ unabhängig voneinander für =O oder =NR⁵, wobei R⁵ für Wasserstoff oder C₁-C₄-Alkyl steht.

Besonders bevorzugt stehen in Formel (I) R¹ und R² für OH und R³ und R⁴ für =O.

Vorzugsweise steht in Formel (II) R⁶ für Wasserstoff oder C₁-C₄-Alkyl das gegebenenfalls ein- oder mehrfach durch OH substituiert ist. Besonders bevorzugt steht in Formel (II) R⁶ für Wasserstoff.

Bezogen auf ein Mol aller im Metallazopigment vorhandenen Metallionen beträgt die Menge an Zn²⁺-und Ni²⁺-Ionen zusammen allgemein 75 bis 99,5 Mol-% und die Menge an Metallionen Me 25 bis 0,5 Mol-%, vorzugsweise beträgt die Menge an Zn²⁺-und Ni²⁺-Ionen zusammen 78 bis 95 Mol-% und die Menge an Metallionen Me 5 bis 23 Mol-%, und besonders bevorzugt beträgt die Menge an Zn²⁺-und Ni²⁺-Ionen zusammen 82 bis 90 Mol-% und die Menge an Metallionen Me 10 bis 18 Mol-%.

Das Molverhältnis von Zn²⁺- zu Ni²⁺- Ionen im Metallazopigment beträgt allgemein 90 : 3 bis 3 :90 , bevorzugt 80 : 5 bis 5 : 80 und besonders bevorzugt 60 :33 bis 33: 60 .

Substituenten in der Bedeutung von Alkyl bezeichnen beispielsweise geradkettiges oder verzweigtes C₁-C₆-Alkyl, vorzugsweise geradkettiges oder verzweigtes C₁-C₄-Alkyl, das gegebenenfalls ein- oder mehrfach, gleich oder verschieden substituiert sein kann, beispielsweise durch Halogen, wie Chlor, Brom oder Fluor, sowie durch -OH, -CN, -NH₂ oder C₁-C₆-Alkoxy.

Die genannten Metallionen Me liegen vorzugsweise in ihren stabilsten Oxidationsstufen vor.Allgemein steht Me für ein zwei- oder dreiwertiges Metallion ausgewählt aus der Reihe La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Er³⁺, Tm³⁺ , Yb²⁺, Yb³⁺ , Mg²⁺, Ca²⁺, Sr²⁺, Ba²⁺, Sc³⁺, Y³⁺, Ti²⁺, Ti³⁺, Zr²⁺, Zr³⁺, V²⁺, V³⁺, Nb³⁺, Cr³⁺, Mo²⁺, Mo³⁺, Mn²⁺, Cd²⁺ und Pb²⁺.

Bevorzugt steht Me für ein 2- oder 3- wertiges Metallion ausgewählt aus der Reihe La³⁺, Ce³⁺, Pr³⁺, Nd³⁺, Sm³⁺, Eu³⁺, Gd³⁺, Tb³⁺, Dy³⁺, Ho³⁺, Er³⁺ , Tm³⁺, Yb³⁺, Mg²⁺, Ca²⁺, Sr²⁺, Y³⁺ und Mn²⁺ und besonders bevorzugt aus der Reihe La³⁺, Ce³⁺, Pr³⁺, Nd³⁺, Sm³⁺, Tb³⁺, Ho³⁺ und Sr²⁺.

Im Fall, dass die Metallazoverbindungen der Komponente a) 2-wertige Metallionen Me enthalten, können die Struktureinheiten der Formel (I) und die Metallionen Me als Komplexverbindungen, beispielsweise solche der Formel (la) 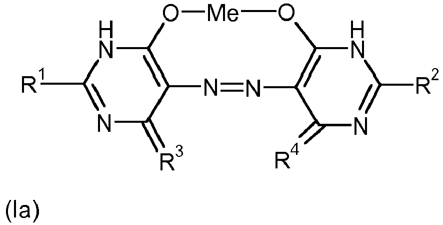 aufgefasst werden. Es ist aber auch möglich, dass das Metallion in einer tautomeren Schreibweise der Formel (la) über die Stickstoffatome gebunden ist.

Die gleiche formelmäßige Darstellung kann auf die Struktureinheiten der Formel (I) mit den Zn²⁺-Ionen bzw. mit den Ni²⁺-Ionen angewendet werden. Diese Darstellung dient nur zur Veranschaulichung und erhebt keinen Anspruch auf wissenschaftliche Korrektheit.

Im Fall, dass Me für ein 3-wertiges Metallion steht erfolgt der Ladungsausgleich vorzugsweise durch eine äquivalente Menge an anionischen Struktureinheiten der Formel (I).

Vorzugsweise erfolgt der Ladungsausgleich der zweifach negativ geladenen Struktureinheiten der Formel (I) zu 80 bis 100%, besonders bevorzugt zu 95 bis 100% und ganz besonders bevorzugt zu 99,9 bis 100% durch die Summe aller im Metallazopigment vorhandenen Zn²⁺, Ni²⁺ und weiteren Metallionen Me.

Vorzugsweise bilden die genannten Metallazoverbindungen der Komponenten a) mit den Komponenten b), d.h. den Verbindungen der Formel (II), Addukte.

Als Addukte sind dabei generell zusammengesetzte Moleküle zu verstehen. Dabei kann die Bindung zwischen den Molekülen beispielsweise durch intermolekulare Wechselwirkungen oder Lewis-Säure-Base Wechselwirkungen oder durch koordinative Bindungen erfolgen.

Der Begriff Addukt soll im Sinne der vorliegenden Erfindung generell alle Arten von Ein- und Anlagerungsverbindungen umfassen.

Unter den Begriffen "Einlagerungsverbindung" oder "Anlagerungsverbindung" im Sinne der vorliegenden Erfindung sollen beispielsweise Verbindungen verstanden werden, die aufgrund von intermolekularen Wechselwirkungen wie Van-der Waals-Wechselwirkungen oder auch Lewis-Säure-Base Wechselwirkungen gebildet werden. Dabei hängt es sowohl von den chemischen Eigenschaften der einzulagernden Komponente, aber auch von der chemischen Natur des Wirtsgitters ab, wie die Einlagerung abläuft. Solche Verbindungen werden häufig auch als Interkalationsverbindungen bezeichnet. Im chemischen Sinn versteht man darunter die Einlagerung von Molekülen, Ionen (selten auch Atomen) in chemische Verbindungen.

Weiterhin sollen darunter auch Einschlussverbindungen, sogenannte Clathrate, verstanden werden. Diese stellen Verbindungen zweier Stoffe dar, von denen ein Gastmolekül in ein Gitter oder Käfig aus einem Wirtsmolekül eingelagert ist.

Unter den Begriffen "Einlagerungsverbindung" oder "Anlagerungsverbindung" im Sinne der vorliegenden Erfindung sollen auch Einlagerungsmischkristalle (auch interstitielle Verbindung) verstanden werden. Es handelt es sich hierbei um chemische, nichtstöchiometrische, kristalline Verbindungen aus mindestens zwei Elementen.

Weiterhin sollen unter den Begriffen "Einlagerungsverbindung" oder "Anlagerungsverbindung" im Sinne der vorliegenden Erfindung auch Verbindungen verstanden werden, die aufgrund von koordinativen Bindungen oder Komplexbindungen gebildet werden. Als solche Verbindungen werden z.B. Substitutionsmischkristall oder Austauschmischkristall bezeichnet, bei dem mindestens zwei Stoffe einen gemeinsamen Kristall bilden und die Atome der zweiten Komponente auf regulären Gitterplätzen der ersten Komponente sitzen.

Bevorzugt sind Metallazopigmente enthaltend die Addukte aus
a) mindestens drei Metallazoverbindungen die sich mindestens in der Art des Metalls unterscheiden und die jeweils Struktureinheiten der oben angegebenen Formel (I),
   worin R¹ und R² für OH stehen,
   und
   R³ und R⁴ für =O stehen,
   und
   Ni²⁺- beziehungsweise Zn²⁺-Ionen und mindestens ein weiteres Metallionen Me enthalten,
   wobei
   Me für ein 2- oder 3-wertiges Metallion ausgewählt aus der Reihe La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Er³⁺, Tm³⁺ , Yb²⁺ und Yb³⁺. Mg²⁺, Ca²⁺, Sr²⁺, Ba²⁺, Sc³⁺, Y³⁺, Ti²⁺, Ti³⁺, Zr²⁺, Zr³⁺, V²⁺, V³⁺, Nb³⁺, Cr³⁺, Mo²⁺, Mo³⁺, Mn²⁺, Cd²⁺ und Pb²⁺ steht, mit der Maßgabe, dass die Menge an Zn²⁺- und Ni²⁺-Ionen zusammen 75 bis 99,5 Mol-% beträgt und die Menge an Metallionen Me 25 bis 0,5 Mol-%, jeweils bezogen auf ein Mol aller Metallionen im Metallazopigment, beträgt,
   und
   wobei das Molverhältnis von Zn²⁺- zu Ni²⁺- Ionen im Metallazopigment 90 : 3 bis 3 : 90 , bevorzugt 80 : 5 bis 5 : 80 und besonders bevorzugt 60 : 33 bis 33 : 60 beträgt,
   und
b) mindestens einer Verbindung der oben angegebenen Formel (II)
   worin
   R⁶ für Wasserstoff steht.

Besonders bevorzugt sind Metallazopigmente enthaltend die Addukte aus a) mindestens drei Metallazoverbindungen die sich mindestens in der Art des Metalls unterscheiden und die jeweils Struktureinheiten der oben angegebenen Formel (I),
worin R¹ und R² für OH stehen,
und
R³ und R⁴ für =O stehen
und
Ni²⁺- beziehungsweise Zn²⁺-Ionen und mindestens ein weiteres Metallion Me enthalten,
wobei
Me für ein 2- oder 3-wertiges Metallion ausgewählt aus der Reihe La³⁺, Ce³⁺, Pr³⁺, Nd³⁺, Sm³⁺, Eu³⁺, Gd³⁺, Tb³⁺, Dy³⁺, Ho³⁺, Er³⁺ , Tm³⁺ und Yb³⁺, Mg²⁺, Ca²⁺, Sr²⁺, Y³⁺ und Mn²⁺, und besonders bevorzugt aus der Reihe La³⁺, Ce³⁺, Pr³⁺, Nd³⁺, Sm³⁺, Tb³⁺, Ho³⁺ und Sr²⁺ steht,
mit der Maßgabe, dass die Menge an Zn²⁺- und Ni²⁺-Ionen zusammen 75 bis 99,5 Mol% beträgt und die Menge an Metallionen Me 25 bis 0,5 Mol-% beträgt, jeweils bezogen auf ein Mol aller Metallionen im Metallazopigment,
und
wobei das Molverhältnis von Zn²⁺- zu Ni²⁺- Ionen im Metallazopigment 90 : 3 bis 3 : 90 bevorzugt 80 : 5 bis 5 : 80 und besonders bevorzugt 60 : 33 bis 33 : 60 beträgt,
und
b) mindestens einer Verbindung der oben angegebenen Formel (II)
worin
R⁶ für Wasserstoff steht.

Verbindung, die geeignet sind mit den Metallazoverbindungen der Komponente a) ein Addukt im Sinne der obigen Definition zu bilden können sowohl organische als auch anorganische Verbindungen sein. Im Folgenden werden diese Verbindungen als Adduktbildnerbezeichnet.

Prinzipiell geeignete Adduktbildner entstammen den verschiedenartigsten Verbindungsklassen. Aus rein praktischen Gründen sind solche Verbindungen bevorzugt, die unter Normalbedingungen (25°C, 1 bar) flüssig oder fest sind.

Von den flüssigen Substanzen sind generell solche bevorzugt, die einen Siedepunkt von 100°C oder darüber, bevorzugt von größer gleich 150°C bei 1 bar, aufweisen. Geeignete Adduktbildner sind generell acyclische und cyclische organische Verbindungen, z.B. aliphatische und aromatische Kohlenwasserstoffe, die substituiert sein können, z.B. durch OH, COOH, NH₂, substituiertes NH₂, CONH₂, substituiertes CONH₂, SO₂NH₂, substituiertes SO₂NH₂, SO₃H, Halogen, NO₂, CN, -SO₂-Alkyl, -SO₂-Aryl, -O-Alkyl, -O-Aryl, -O-Acyl.

Carbonsäure- und Sulfonsäureamide sind eine bevorzugte Gruppe von Adduktbildnern, insbesondere geeignet sind auch Harnstoff und substituierte Harnstoffe wie Phenylharnstoff, Dodecylharnstoff und andere sowie deren Polykondensate mit Aldehyden, insbesondere Formaldehyd; Heterocyclen wie Barbitursäure, Benzimidazolon, Benzimidazolon-5-sulfonsäure, 2,3-Dihydroxychinoxalin, 2,3-Dihydroxychinoxalin-6-sulfonsäure, Carbazol, Carbazol-3,6-disulfonsäure, 2-Hydroxychinolin, 2,4-Dihydroxychinolin, Caprolactam, Melamin, 6-Phenyl-1,3,5-triazin-2,4-diamin, 6-Methyl-1,3,5-triazin-2,4-diamin, Cyanursäure.

Ebenfalls als Adduktbildner prinzipiell geeignet sind Polymere, vorzugsweise wasserlösliche Polymere, z.B. Ethylen-propylenoxid-Blockpolymere, vorzugsweise mit einem Mₙ größer gleich 1.000, insbesondere von 1.000 bis 10.000 g/mol, Polyvinylalkohol, Poly-(meth)-acrylsäuren, modifizierte Cellulose, wie Carboxymethylcellulosen, Hydroxyethyl- und -propylcellulosen, Methyl- und Ethylhydroxyethylcellulosen.

Erfindungsgemäß werden als Adduktbildner solche der Formel (II) eingesetzt. Insbesondere bevorzugt ist dabei Melamin.

Im Allgemeinen enthalten die erfindungsgemäßen Metallazopigmente pro Mol an Sturktureinheiten der Formel (I) 0,05 bis 4 Mol, bevorzugt 0,5 bis 2,5 Mol und ganz besonders bevorzugt 1,0 bis 2,0 Mol an Verbindungen der Formel (II).

Die erfindungsgemäßen Metallazopigmente besitzten vorzugsweise eine spezifische Oberfläche (m²/g) von 50 bis 200 m²/g, insbesondere 80 bis 160 m²/g, ganz besonders bevorzugt 100 bis 150 m²/g. Die Oberfläche wird nach DIN 66131 ermittelt: Bestimmung der spezifischen Oberfläche von Feststoffen durch Gasadsorption nach Brunauer, Emmett und Teller (B.E.T).

Bei den erfindungsgemäßen Metallazopigmenten kann es sich um physikalische Mischungen oder um chemische Mischverbindungen handeln.

Vorzugsweise handelt es sich bei den physikalischen Mischungen um Mischungen von Addukten aus den genannten Metallazoverbindungen der Komponente a) und den Verbindungen der Formel (II) der Komponente b) die sich zumindest hinsichtlich der Art der Metalle unterscheiden. Beispielsweise und bevorzugt handelt es sich um die physikalische Mischung der Addukte aus a1) der reinen Ni-Azoverbindung mit b1) Melamin und der Addukte aus a2) der reinen Zn-Azoverbindung mit b2) Melamin und der Addukte aus a3) mindestens einer weiteren Me-Azoverbindung mit b3) Melamin.

Bei den chemischen Mischverbindungen handelt es sich beispielsweise und bevorzugt um Addukte von Metallazoverbindungen der Komponente a) mit Verbindungen der Formel (II) der Komponente b), vorzugsweise Melamin, bei denen die Zn²⁺- und Ni²⁺-Ionen, und gegebenenfalls weitere Metallion Me, in ein gemeinsames Kristallgitter eingebaut sind.

Die erfindungsgemäßen Metallazopigmente können hergestellt werden durch Umsetzung von Alkalisalzen der Formel (III), oder deren Tautomeren, bevorzugt der Natrium- oder Kaliumsalze, in Gegenwart von mindestens einer Verbindung der Formel (II) mit Nickel- und Zinksalzen und einem oder mehreren Metallsalzen aus der Reihe der Lanthan-, Cer-, Praseodym-, Neodym-, Samarium-, Europium-, Gadolinium-, Terbium-, Dysprosium-, Holmium-, Ytterbium-, Erbium-, Thulium-, Magnesium-, Kalzium-, Strontium-, Barium-, Yttrium-, Scandium-, Titan-, Niob-, Molybdän-, Mangan-, Vanadium-, Zirkonium-, Cadmium-, Chrom- und Bleisalze, bevorzugt aus der Reihe der Lanthan-, Cer-, Praseodym-, Neodym-, Samarium-, Europium-, Gadolinium-, Terbium, Dysprosium-, Holmium-, Ytterbium-, Erbium-, Thulium-, Magnesium-, Kalzium-, Strontium-, Mangan- und Yttriumsalze, und besonders bevorzugt aus der Reihe der Lanthan-, Cer-, Praseodym-, Neodym-, Samarium-, Terbium-, Holmium- und Strontiumsalze.

Die erfindungsgemäßen Metallazopigmente können auch hergestellt werden durch Mischen der Addukte aus a1) Metallazoverbindungen die Stuktureinheiten der Formel (I) und Ni²⁺-Ionen enthalten und b1) Verbindungen der Formel (II) mit Addukten aus a2) Metallazoverbindungen die Struktureinheiten der Formel (I) und Zn²⁺-Ionen enthalten und b2) Verbindungen der Formel (II) mit Addukten aus a3) Metallazoverbindungen die Sturktureinheiten der Formel (I) und Metallionen Me enthalten und b3) Verbindungen der Formel (II).

Weiterer Gegenstand der vorliegenden Erfindung ist ein Verfahren zur Herstellung der erfindungsgemäßen Metallazopigmente das dadurch gekennzeichnet ist, dass man mindestens eine Verbindung der Formel (III), oder deren Tautomere, 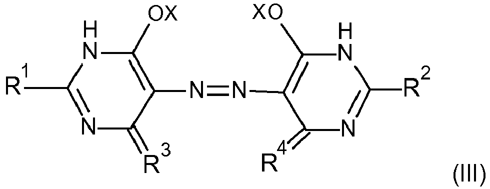 worin
X für ein Alkalimetallion, vorzugsweise für ein Natrium- oder Kaliumion steht,
R¹ und R² unabhängig voneinander für OH, NH₂ oder NHR⁵ stehen,
R³ und R⁴ unabhängig voneinander für =O oder =NR⁵ stehen, und
R⁵ für Wasserstoff oder Alkyl, bevorzugt C₁-C₄-Alkyl, steht,

in Gegenwart von mindestens einer Verbindung der Formel (II) gleichzeitig oder nacheinander mit mindestens einem Nickelsalz und mindestens einem Zinksalz und mit mindestens einem weiteren Metallsalz aus der Reihe der La³⁺-, Ce³⁺-, Pr³⁺-, Nd²⁺-, Nd³⁺-, Sm²⁺-, Sm³⁺-, Eu²⁺-, Eu³⁺-, Gd³⁺-, Tb³⁺-, Dy³⁺-, Ho³⁺-, Er³⁺-, Tm³⁺-, Yb²⁺-, Yb³⁺-, Mg²⁺-, Ca²⁺-, Sr⁺²-, Ba²⁺-, Sc³⁺-, Y³⁺-, Ti²⁺-, Ti³⁺-, Zr²⁺-, Zr³⁺-, V²⁺-, V³⁺-, Nb³⁺-, Cr³⁺-, Mo²⁺-, Mo³⁺-, Mn²⁺-, Cd²⁺- und Pb²⁺-Salze, bevorzugt aus der Reihe La³⁺-, Ce³⁺-, Pr³⁺-, Nd³⁺-, Sm³⁺-, Eu³⁺-, Gd³⁺-, Tb³⁺-, Dy³⁺-, Ho³⁺-, Er³⁺-, Tm³⁺-, Yb³⁺-, Mg²⁺-, Ca²⁺-, Sr²⁺-, Y³⁺- und Mn²⁺-Salze und besonders bevorzugt aus der Reihe La³⁺-, Ce³⁺-, Pr³⁺-, Nd³⁺-, Sm³⁺-, Tb³⁺-, Ho³⁺- und Sr²⁺-Salze umsetzt, wobei pro Mol an Verbindung der Formel (III) 0,03 bis 0,95 Mol mindestens eines Nickelsalzes, 0,03 bis 0,95 Mol mindestens eines Zinksalzes und 0,005 bis 0,25 Mol mindestens eines weiteren Metallsalzes aus der oben genannten Reihe der Metallsalze eingesetzt werden, und die Summe der Molmengen all dieser Metallsalze insgesamt ein Mol beträgt.

Bevorzugt werden pro Mol an Verbindung der Formel (III) 0,05 bis 0,8 Mol mindestens eines Nickelsalzes und 0,05 bis 0,8 Mol mindestens eines Zinksalzes und 0,01 bis 0,2 Mol mindestens eines weiteren Metallsalzes aus der oben genannten Reihe eingesetzt.

Ganz besonders bevorzugt werden pro Mol an Verbindung der Formel (III) 0,3 bis 0,6 Mol mindestens eines Nickelsalzes und 0,3 bis 0,6 Mol mindestens eines Zinksalzes und 0,12 bis 0,18 Mol mindestens eines weiteren Metallsalzes aus der oben genannten Reihe eingesetzt.

Im Allgemeinen werden zur Durchführung des erfindungsgemäßen Verfahrens pro Mol an Verbindung der Formel (III) 0,05 bis 4 Mol, bevorzugt 0,5 bis 2,5 Mol und ganz besonders bevorzugt 1,0 bis 2,0 Mol an Verbindung der Formel (II) eingesetzt.

Alternativ kann zur Herstellung an Stelle der Dialkaliverbindung der Formel (III) auch eine Monoalkaliverbindung der Formel (IIIa), oder deren Tautomere, 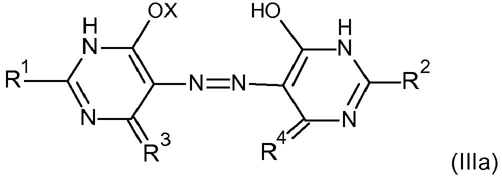 worin X, R¹ R² , R³ und R⁴ die für Formel (III) angegebene Bedeutung haben,
oder eine Mischung aus Verbindungen der Formel (III) und (IIIa) eingesetzt werden. Dabei beziehen sich die angegebenen Molmengen an Nickel- und Zinksalzen und den weitern Metallsalzen aus der oben genannten Reihe sowie an Verbindungen der Formel (II) in diesen Fällen auf die Summe der Molmenge der eingesetzten Verbindungen (III) und (IIIa).

Das erfindungsgemäße Verfahren wird im Allgemeinen bei einer Temperatur von 60 bis 95 °C in wässriger Lösung bei einem pH-Wert unterhalb von 7 durchgeführt. Die erfindungsgemäß einzusetzenden Nickel- und Zinksalze und die weiteren Metallsalze aus der oben genannten Reihe können einzeln oder als Gemisch untereinander, bevorzugt in Form einer wässrigen Lösung eingesetzt werden. Die Verbindungen der Formel (II) können ebenfalls einzeln oder als Mischung untereinander zugegeben werden, bevorzugt in Form der Feststoffe.

Im Allgemeinen wird das erfindungsgemäße Verfahren so durchgeführt, dass die Azoverbindung der Formel (III), vorzugsweise als Na- oder K-Salz, vorgelegt wird, eine oder mehrere Verbindungen der Formel (II), vorzugsweise Melamin, zugegeben wird, und danach, gleichzeitig oder nacheinander, mit mindestens einem Nickelsalz und mindestens einem Zinksalz und einem oder mehreren Metallsalzen aus der oben angegebenen Reihe, vorzugsweise in Form der wässrigen Lösungen dieser Salze, umgesetzt wird, vorzugsweise bei pH-Werten kleiner 7. Zur Einstellung des pH-Wertes eignen sich Natronlauge, Kalilauge, Natriumcarbonat, Natriumhydrogencarbonat, Kaliumcarbonat und Kaliumhydrogencarbonat.

Als Nickel- und Zinksalze kommen vorzugsweise deren wasserlösliche Salze in Frage, insbesondere Chloride, Bromide, Acetate, Formiate, Nitrate, Sulfate usw. Bevorzugt eingesetzte Nickel- und Zinksalze besitzen eine Wasserlöslichkeit von mehr als 20 g/l, insbesondere mehr als 50 g/l bei 20°C.

Als weitere Metallsalze aus der Reihe der Lanthan-, Cer-, Praseodym-, Neodym-, Samarium-, Europium-, Gadolinium-, Terbium-, Dysprosium-, Holmium-, Ytterbium-, Erbium-, Thulium-, Magnesium-, Kalzium-, Strontium-, Barium-, Yttrium-, Scandium-, Titan-, Niob-, Molybdän-, Mangan-, Vanadium-, Zirkonium-, Cadmium-, Chrom- und Bleisalze kommen vorzugsweise deren wasserlösliche Salze in Frage, insbesondere deren Chloride, Bromide, Acetate, Nitrate und Sulfate, bevorzugt deren Chloride.

Die auf diese Weise erhaltenen erfindungsgemäßen Metallazopigmente können dann durch Filtration ihrer wässrigen Suspension als wässriger Nutschkuchen isoliert werden. Dieser Nutschkuchen kann, gegebenenfalls nach Waschen mit heißem Wasser, mittels üblicher Trocknungsverfahren getrocknet werden.

Als Trocknungsverfahren kommen beispielsweise die Schaufeltrocknung oder die Sprühtrocknung entsprechender wässriger Slurries in Frage.

Anschließend kann das Pigment nachgemahlen werden.

Sofern die erfindungsgemäßen Metallazopigmente für die gewünschte Anwendung zu kornhart bzw. zu dispergierhart sind, können sie beispielsweise gemäß der in DE-A 19 847 586 beschriebenen Methode in kornweiche Pigmente umgewandelt werden.

Weiterer Gegenstand der vorliegenden Erfindung ist ein Verfahren zur Herstellung der erfindungsgemäßen Metallazopigmenten das dadurch gekennzeichnet ist, dass man
(i) mindestens ein Addukt aus
   a1) einer Metallazoverbindung die Struktureinheiten der oben angegebenen Formel (I),
      worin
      R¹, R², R³, R⁴ und R⁵ die oben angegebenen allgemeinen und bevorzugten Bedeutung haben,
      und
      Zn²⁺-Ionen enthält,
      und
   b1) mindestens einer Verbindung der oben angegebenen Formel (II), worin R⁶ die oben angegebenen allgemeinen und bevorzugten Bedeutungen hat,
      und die Menge an Zn²⁺-Metallionen 100 Mol-% beträgt, bezogen auf ein Mol aller Metallionen im Addukt a1)/b1),
   mit
(ii) mindestens einem Addukt aus
   a2) einer Metallazoverbindung die Struktureinheiten der oben angegebenen Formel (I),
   worin
   R¹, R², R³, R⁴ und R⁵ die oben angegebenen allgemeinen und bevorzugten Bedeutung haben,
   Ni²⁺-Ionen enthält,
   und
   b2) mindestens einer Verbindung der oben angegebenen Formel (II), worin R⁶ die oben angegebenen allgemeinen und bevorzugten Bedeutungen hat,
   und die Menge an Ni²⁺-Metallionen 100 Mol-% beträgt, bezogen auf ein Mol aller Metallionen im Addukt a2)/b2),
   und

(iii) mindestens einem Addukt aus
   a3) einer Metallazoverbindung die Struktureinheiten der oben angegebenen Formel (I),
   worin
   R¹, R², R³, R⁴ und R⁵ die oben angegebenen allgemeinen und bevorzugten Bedeutung haben,
   und
   mindestens ein Metallion Me enthält,
   und
   b3) mindestens einer Verbindung der oben angegebenen Formel (II), worin R⁶ die oben angegebenen allgemeinen und bevorzugten Bedeutungen hat,
   und die Menge an Me-Metallionen 100 Mol-% beträgt, bezogen auf ein Mol aller Metallionen im Addukt a3)/b3),
miteinander vermischt, wobei pro Mol an Addukt a1)/b1) 0,03 bis 30 Mol an Addukt a2)/b2) eingesetzt werden und 0,005 bis 0,33 Mol an Addukt a3)/b3) eingesetzt werden bezogen auf die Summe der Molmenge an Addukt a1/)b1) und a2)/b2).

Die erfindungsgemäßen Metallazopigmente zeichnen sich durch besonders gute Dispergierbarkeit und eine hohe Farbstärke aus. Chroma und Transparenz sind hervorragend einstellbar.

Die erfindungsgemäßen Metallazopigmente eignen sich hervorragend für alle Pigmentanwendungszwecke, insbesondere auch in Form ihrer Pigmentpräparationen.

Ein weiterer Gegenstand der vorliegenden Erfindung sind Pigmentpräparationen enthaltend wenigstens ein erfindungsgemäßes Metallazopigment und wenigstens einen Hilfs- und/oder Zusatzstoff.

Als Hilfs- oder Zusatzstoffe kommen im allgemeinen alle für Pigmentpräparationen üblichen Zusätze in Frage, beispielsweise solche aus der Reihe der oberflächenaktiven Mittel wie Dispergiermittel, Tenside, Netzmittel, Emulgatoren, sowie solche aus der Reihe der Oberflächenbelegungsmittel, der Basen und Lösungsmittel. Prinzipiell richtet sich der Hilfs-oder Zusatzstoff nach der Art des Zielsystems. Ist das Zielsystem z.B. ein Lack oder eine Druckfarbe dann wird der Hilfs- oder Zusatzstoff so ausgewählt, dass eine möglichst hohe Kompatibilität mit dem Zielsystem erreicht wird.

Vorzugsweise enthalten die erfindungsgemäßen Pigmentpräparationen mindestens ein oberflächenaktives Mittel.

Unter oberflächenaktiven Mitteln im Rahmen der vorliegenden Erfindung werden insbesondere Dispergiermittel verstanden, die die Pigmentteilchen in ihrer feinen partikulären Form in wässrigen Medien stabilisieren. Unter fein partikulär wird vorzugsweise eine Feinverteilung von 0,001 bis 5 µm verstanden, insbesondere von 0,005 bis 1 µm, besonders bevorzugt von 0,005 bis 0,5 µm. Die erfindungsgemäßen Pigmentpräparation liegt vorzugsweise fein partikulär vor.

Geeignete oberflächenaktive Mittel sind beispielsweise anionischer, kationischer, amphoterer oder nichtionogener Natur.

Geeignete anionische oberflächenaktive Mittel (c) sind insbesondere Kondensationsprodukte von aromatischen Sulfonsäuren mit Formaldehyd, wie Kondensationsprodukte aus Formaldehyd und Alkylnaphthalinsulfonsäuren oder aus Formaldehyd, Naphthalinsulfonsäuren und/oder Benzolsulfonsäuren, Kondensationsprodukte aus gegebenenfalls substituiertem Phenol mit Formaldehyd und Natriumbisulfit. Geeignet sind außerdem oberflächenaktive Mittel aus der Gruppe der Sulfobernsteinsäureester sowie Alkylbenzolsulfonate. Außerdem ionisch modifizierte, insbesondere sulfatierte oder carboxilierte, alkoxylierte Fettsäurealkohole oder deren Salze. Als alkoxylierte Fettsäurealkohole werden insbesondere solche mit 5 bis 120, vorzugsweise 5 bis 60, insbesondere mit 5 bis 30 Mol Ethylenoxid versehene C₆-C₂₂-Fettsäurealkohole, die gesättigt oder ungesättigt sind, verstanden. Weiterhin kommen vor allem Ligninsulfonate in Betracht, z.B. solche, die nach dem Sulfit- oder Kraft-Verfahren gewonnen werden. Vorzugsweise handelt es sich um Produkte, die zum Teil hydrolysiert, oxidiert, propoxyliert, sulfoniert, sulfomethyliert oder desulfoniert und nach bekannten Verfahren fraktioniert werden, z.B. nach dem Molekulargewicht oder nach dem Sulfonierungsgrad. Auch Mischungen aus Sulfit- und Kraftligninsulfonaten sind gut wirksam. Besonders geeignet sind Ligninsulfonate mit einem durchschnittlichen Molekulargewicht zwischen 1 000 und 100 000 g/mol, einem Gehalt an aktivem Ligninsulfonat von mindestens 80 Gew.-% und vorzugsweise mit niedrigem Gehalt an mehrwertigen Kationen. Der Sulfonierungsgrad kann in weiten Grenzen variieren.

Als nichtionische oberflächenaktive Mittel kommen beispielsweise in Frage: Umsetzungsprodukte von Alkylenoxiden mit alkylierbaren Verbindungen, wie z.B. Fettalkoholen, Fettaminen, Fettsäuren, Phenolen, Alkylphenolen, Arylalkylphenolen, wie Styrol-Phenol-Kondensate, Carbonsäureamiden und Harzsäuren. Hierbei handelt es sich z.B. um Ethylenoxidaddukte aus der Klasse der Umsetzungsprodukte von Ethylenoxid mit:
1) gesättigten und/oder ungesättigten Fettalkoholen mit 6 bis 22 C-Atomen oder
2) Alkylphenolen mit 4 bis 12 C-Atomen im Alkylrest oder
3) gesättigten und/oder ungesättigten Fettaminen mit 14 bis 20 C-Atomen oder
4) gesättigten und/oder ungesättigten Fettsäuren mit 14 bis 20 C-Atomen oder
5) hydrierte und/oder unhydrierte Harzsäuren.

Als Ethylenoxid-Addukte kommen insbesondere die unter 1) bis 5) genannten alkylierbaren Verbindungen mit 5 bis 120, insbesondere 5 bis 100, insbesondere 5 bis 60, besonders bevorzugt 5 bis 30 Mol Ethylenoxid in Frage.

Als oberflächenaktive Mittel eignen sich ebenfalls die aus DE-A 19 712 486 oder aus DE-A 19 535 246 bekannten Ester des Alkoxylierungsproduktes der Formel (X), die der Formel (XI) entsprechen sowie diese gegebenenfalls in Mischung mit den zugrundeliegenden Verbindungen
der Formel (X). Das Alkoxylierungsprodukt eines Styrol-Phenol-Kondensats der Formel (X) ist wie nachfolgend definiert: 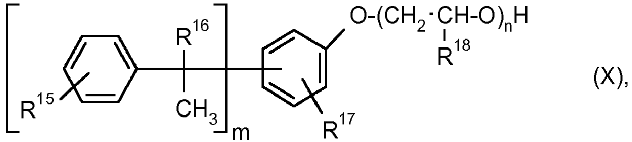 in der
- R¹⁵: Wasserstoff oder C₁-C₄-Alkyl bedeutet,
- R¹⁶: für Wasserstoff oder CH₃ steht,
- R¹⁷: Wasserstoff, C₁-C₄-Alkyl, C₁-C₄-Alkoxy, C₁-C₄-Alkoxycarbonyl oder Phenyl bedeutet,
- m: eine Zahl von 1 bis 4 bedeutet,
- n: eine Zahl von 6 bis 120 bedeutet,
- R¹⁸: für jede durch n indizierte Einheit gleich oder verschieden ist und für Wasserstoff, CH₃ oder Phenyl steht, wobei im Falle der Mitanwesenheit von CH₃ in den verschiedenen -(-CH₂-CH(R¹⁸)-O-)-Gruppen in 0 bis 60 % des Gesamtwertes von n R¹⁸ für CH₃ und in 100 bis 40 % des Gesamtwertes von n R¹⁸ für Wasserstoff steht und wobei im Falle der Mitanwesenheit von Phenyl in den verschiedenen -(-CH₂-CH(R¹⁸)-O-)-Gruppen in 0 bis 40 % des Gesamtwertes von n R¹⁸ für Phenyl und in 100 bis 60 % des Gesamtwertes von n R¹⁸ für Wasserstoff steht.

Die Ester der Alkoxylierungsprodukte (X) entsprechen der Formel (XI) 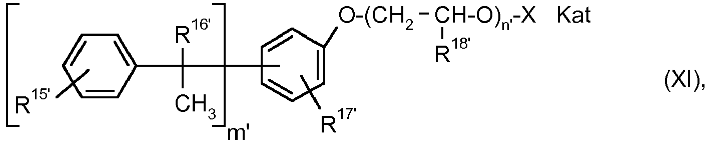 in der
- R^{15'}, R^{16'}, R^{17'}, R^{18'}, m' und n': den Bedeutungsumfang von R¹⁵, R¹⁶, R¹⁷, R¹⁸, m bzw. n, jedoch unabhängig hiervon, annehmen,
- X: die Gruppe -SO₃, -SO₂, -PO₃ oder -CO-(R¹⁹)-COO bedeutet,
- Kat: ein Kation aus der Gruppe von H, Li, Na, K, NH₄ oder HO-CH₂CH₂-NH₃ ist, wobei im Falle von X = -PO₃ zwei Kat vorliegen und
- R¹⁹: für einen zweiwertigen aliphatischen oder aromatischen Rest steht, vorzugsweise für C₁-C₄-Alkylen, insbesondere Ethylen, C₂-C₄- einfach ungesättigte Reste, insbesondere Acetylen oder gegebenenfalls substituiertes Phenylen, insbesondere ortho-Phenylen steht, wobei als mögliche Substituenten vorzugsweise C₁-C₄-Alkyl, C₁-C₄-Alkoxy, C₁-C₄-Alkoxycarbonyl oder Phenyl in Frage kommen.

Als ein bevorzugtes oberflächenaktive Mittel wird die Verbindung der Formel (XI) eingesetzt. Vorzugsweise eine Verbindung der Formel (XI), worin X einen Rest der Formel -CO-(R¹⁹)-COO⁻ bedeutet und R¹⁹ die obige Bedeutung besitzt.

Bevorzugt ist es ebenfalls als oberflächenaktive Mittel eine Verbindung der Formel (XI) zusammen mit einer Verbindung der Formel (X) einzusetzen. Vorzugsweise enthält das oberflächenaktive Mittel in diesem Fall 5 bis 99 Gew.-% der Verbindung (XI) und 1 bis 95 Gew.-% der Verbindung (X).

Das oberflächenaktive Mittel der Komponente (c) wird vorzugsweise in einer Menge von 0,1 bis 100 Gew.-%, insbesondere 0,5 bis 60 Gew.-%, bezogen auf das eingesetzte erfindungsgemäße Metallazopigment, in der Pigmentpräparation, verwendet.

Selbstverständlich kann die erfindungsgemäße Pigmentpräparation noch weitere Zusätze enthalten. So können beispielsweise die Viskosität einer wässrigen Suspension erniedrigende und/oder den Feststoffgehalt erhöhende Zusätze wie beispielsweise Carbonsäure- und Sulfonsäureamide in einer Menge von bis zu 10 Gew.-%, bezogen auf die Pigmentpräparation zugesetzt werden.

Weitere Zusätze sind beispielsweise anorganische und organische Basen sowie für Pigmentpräparation übliche Zusätze.

Als Basen sind zu nennen: Alkalihydroxide, wie beispielsweise NaOH, KOH oder organische Amine wie Alkylamine, insbesondere Alkanolamine oder Alkylalkanolamine.

Als besonders bevorzugt sind zu nennen Methylamin, Dimethylamin, Trimethylamin, Ethanolamin, n-Propanolamin, n-Butanolamin, Diethanolamin, Triethanolamin, Methylethanolamin oder Dimethylethanolamin.

Als Carbonsäure- und Sulfonsäureamide sind beispielsweise geeignet: Harnstoff und substituierte Harnstoffe wie Phenylharnstoff, Dodecylharnstoff und andere; Heterocyclen wie Barbitursäure, Benzimidazolon, Benzimidazolon-5-sulfonsäure, 2,3-Dihydroxychinoxalin, 2,3-Dihydroxychinoxalin-6-sulfonsäure, Carbazol, Carbazol-3,6-disulfonsäure, 2-Hydroxychinolin, 2,4-Dihydroxychinolin, Caprolactam, Melamin, 6-Phenyl-1,3,5-triazin-2,4-diamin, 6-Methyl-1,3,5-triazin-2,4-diamin, Cyanursäure.

Die Base ist gegebenenfalls bis zu einer Menge von 20 Gew.-%, vorzugsweise bis 10 Gew.-%, bezogen auf das Pigment enthalten.

Weiterhin können die erfindungsgemäßen Pigmentpräparationen herstellungsbedingt noch anorganische und/oder organische Salze enthalten.

Die erfindungsgemäßen Pigmentpräparationen sind vorzugsweise bei Raumtemperatur fest. Insbesondere liegen die erfindungsgemäßen Pigmentpräparationen als Pulver oder Granulate vor.

Die erfindungsgemäßen Pigmentpräparationen eignen sich hervorragend für alle Pigmentanwendungszwecke.

Weiterer Gegenstand der vorliegenden Erfindung ist die Verwendung mindestens eines erfindungsgemäßen Metallazopigments oder einer erfindungsgemäßen Pigmentpräparation zum Pigmentieren von Lacken aller Art für die Herstellung von Druckfarben, Leimfarben oder Binderfarben, für die Massefärbung von Papier, für die Massefärbung von synthetischen, halbsynthetischen oder natürlichen makromolekularen Stoffen, wie z.B. Polyvinylchlorid, Polystyrol, Polyamid, Polyethylen oder Polypropylen. Sie können auch für die Spinnfärbung von natürlichen, regenerierten oder künstlichen Fasern, wie z.B. Cellulose-, Polyester-, Polycarbonat-, Polyacrylnitril- oder Polyamidfasern, sowie zum Bedrucken von Textilien und Papier verwendet werden. Aus diesen Pigmenten können feinteilige, stabile, wässrige Pigmentierungen von Dispersions- und Anstrichfarben, die für die Papierfärbung, für den Pigmentdruck von Textilien, für den Laminatdruck oder für die Spinnfärbung von Viskose brauchbar sind, durch Mahlen oder Kneten in Gegenwart von nichtionogenen, anionischen oder kationischen Tensiden hergestellt werden.

Die erfindungsgemäßen Metallazopigmente eignen sich weiterhin hervorragend für Ink Jet Anwendungen und für Farbfilter für Flüssigkristallanzeigen.

In einer ebenfalls bevorzugten Ausführungsform enthalten die erfindungsgemäßen Pigmentpräparationen wenigstens eine organische Verbindung (d) ausgewählt aus der Gruppe der Terpene, Terpenoide, Fettsäuren, Fettsäureester und der Homo- oder Copolymere, wie statistische- oder Block-Copolymere mit einer Löslichkeit in pH neutralem Wasser bei 20°C von weniger als 1 g/l, insbesondere weniger als 0,1 g/l. Die organische Verbindung (d) ist vorzugsweise bei Raumtemperatur (20°C) unter Normalatmosphäre fest oder flüssig und weist im Falle, dass sie flüssig ist, einen Siedepunkt von vorzugsweise >100°C, insbesondere >150°C auf.

Bevorzugte Polymere besitzen sowohl einen hydrophilen wie auch einen hydrophoben vorzugsweise polymeren Molekülteil. Beispiele derartiger Polymere sind statistische Copolymere auf Basis von Fettsäuren oder langkettigen C₁₂-C₂₂-Kohlenwasserstoffen und Polyalkylenglykolen, insbesondere Polyethylenglykol. Ferner Block-Copolymere auf Basis von (Poly)Hydroxy Fettsäuren und Polyalkylenglykol, insbesondere Polyethylenglykol, sowie Pfropf-Copolymere auf Basis von Poly(meth)acrylat und Polyalkylenglykol, insbesondere Polyethylenglykol.

Als bevorzugte Verbindungen aus der Gruppe der Terpene, Terpenoide, Fettsäuren und Fettsäureester seien genannt: Ocimen, Myrcen, Geraniol, Nerol, Linalool, Citronellol, Geranial, Citronellal, Neral, Limonen, Menthol, beispielsweise (-)-Menthol, Menthon oder bicyclische Monoterpene, gesättigte und ungesättigte Fettsäuren mit 6 bis 22 C-Atomen, wie beispielsweise Ölsäure, Linolsäure und Linolensäure oder Mischungen davon.

Als organische Verbindungen der Komponente (d) kommen ferner auch die oben genannten Adduktbildner infrage soweit sie den für die Verbindung der Komponente (d) gewünschten Kriterien gehorchen.

Besonders bevorzugte Pigmentpräparationen enthalten:

| | |
|---|---|
| 50 - 99 Gew.-% | an wenigstens einem erfindungsgemäßen Metallazopigment und |
| | |
| 1 - 50 Gew.-% | vorzugsweise 2 bis 50 Gew.-% an wenigstens einer Verbindung der Komponente (d). |

Gegebenenfalls enthält die erfindungsgemäße Pigmentpräparation zusätzlich ein oberflächenaktives Mittel (c).

Besonders bevorzugt bestehen die erfindungsgemäßen Präparationen zu mehr als 90 Gew.-%, vorzugsweise mehr als 95 Gew.-% und insbesondere mehr als 97 Gew.-% aus mindestens einem erfindungsgemäßen Metallazopigment, mindestens einer organischen Verbindung der Komponente (d) und gegebenenfalls mindestens einem oberflächenaktiven Mittel der Komponente (c) und gegebenenfalls mindestens einer Base.

Die erfindungsgemäßen Pigmentpräparationen dieser Zusammensetzung eignen sich insbesondere zur Pigmentierung von Ink Jet Tinten und von Farbfiltern für Flüssigkristallanzeigen.

Ein weiterer Gegenstand der vorliegenden Erfindung ist ein Verfahren zur Herstellung der erfindungsgemäßen Pigmentpräparationen das dadurch gekennzeichnet ist, dass man mindestens ein erfindungsgemäßes Metallazopigment, und mindestens einen Hilfs- oder Zusatzstoff, insbesondere mindestens eine organischen Verbindung der Komponente (d) und gegebenenfalls mindestens ein oberflächenaktives Mittel der Komponente (c) und gegebenenfalls mindestens eine Base, miteinander vermischt.

Ebenfalls Gegenstand der vorliegenden Erfindung ist die Verwendung der erfindungsgemäßen Metallazopigmente oder der erfindungsgemäßen Pigmentpräparationen zur Herstellung von Farbfiltern für Flüssigkristallanzeigen. Im Folgenden sei diese Verwendung am Beispiel der Pigment-Dispersionsmethode nach dem Photolackverfahren beschrieben.

Die erfindungsgemäße Verwendung der erfindungsgemäßen Pigmentpräparationen zur Herstellung von Farbfiltern ist beispielsweise dadurch gekennzeichnet, dass mindestens ein erfindungsgemäßes Metallazopigment oder eine erfindungsgemäße Pigmentpräparation, insbesondere feste Pigmentpräparation, gegebenenfalls mit einem Bindemittelharz und einem organischen Lösungsmittel, gegebenenfalls unter Zusatz eines Dispergiermittels, homogenisiert und anschließend kontinuierlich oder diskontinuierlich auf eine Teilchengröße nach Anzahl (elektronenmikroskopische Bestimmung) von 99,5% <1000 nm, vorzugsweise 95 % <500 nm und insbesondere 90 % <200 nm nasszerkleinert wird.

Als Nasszerkleinerungsverfahren kommen beispielsweise Rührer- oder Dissolverdispergierung, Mahlen mittels Rührwerkskugel- oder -perlmühlen, Kneter, Walzenstuhl, Hochdruckhomogenisierung oder Ultraschalldispergierung in Frage.

Während der Dispergierbehandlung oder im Anschluss daran erfolgt die Zugabe von mindestens einem photohärtbaren Monomeren und einem Photoinitiator. Im Anschluss an die Dispergierung kann noch weiteres Bindemittelharz, Lösungsmittel oder für Photolacke übliche Zuschlagstoffe eingebracht werden, wie es für die gewünschte photosensitive Beschichtungsmitteleinstellung (Photolack) zur Herstellung der Farbfilter erforderlich ist. Im Rahmen dieser Erfindung wird unter Photolack eine Präparation verstanden, die wenigstens ein photohärtbares Monomer und einen Photoinitiator enthält.

Gegenstand der vorliegenden Erfindung ist auch ein Verfahren zur Herstellung von Farbfiltern für Flüssigkristallanzeigen das dadurch gekennzeichnet ist, dass man mindestens ein erfindungsgemäßes Metallazopigment oder eine erfindungsgemäße Pigmentpräparation, gegebenenfalls mit einem Bindemittelharz und einem organischen Lösungsmittel, gegebenenfalls unter Zusatz eines Dispergiermittels, homogenisiert und anschließend kontinuierlich oder diskontinuierlich auf eine Teilchengröße nach Anzahl (elektronenmikroskopische Bestimmung) von 99,5 % <1000 nm, nasszerkleinert und während der Dispergierbehandlung oder im Anschluss daran mindestens ein photohärtbares Monomer und einem Photoinitiator zugibt.

Als mögliche Dispergiermittel kommen allgemein handelsübliche, für diesen Anwendungszweck geeignete Dispergiermittel wie beispielsweise polymere, ionogene oder nicht-ionogene Dispergiermittel bspw. auf Basis von Polycarbonsäuren oder Polysulfonsäuren, sowie Polyethylenoxid-Polypropylenoxid-Block-Copolymere in Betracht. Ferner können auch Derivate organischer Farbstoffe als Dispergiermittel oder Co-Dispergiermittel verwendet werden.

Bei der Herstellung der Farbfilter fallen daher "Zubereitungen" an, die bezogen auf die Zubereitung enthalten:
- wenigstens ein erfindungsgemäßes Metallazopigment,
- gegebenenfalls ein Bindemittelharz,
- wenigstens ein organisches Lösungsmittel sowie
- gegebenenfalls ein Dispergiermittel.

In einer bevorzugten Ausführungsform enthält die Zubereitung (Angaben bezogen auf Zubereitung):

| | |
|---|---|
| 1 - 50 Gew.-% | eines erfindungsgemäßen Metallazopigments |
| | |
| 0 - 20 Gew.-% | Bindemittelharz |
| | |
| 0 - 20 Gew.-% | Dispergiermittel |
| | |
| 10 - 94 Gew.-% | organisches Lösungsmittel |

Die Beschichtung des Photolackes auf eine Platte zur Erzeugung der gefärbten Bildelementmuster kann entweder durch direkten oder indirekten Auftrag geschehen. Als Auftragsmethoden seien bspw. genannt: Roller-Coating, Spin-Coating, Spray-Coating, Dip-Coating und Air-Knife-Coating.

Als Platten kommen je nach Verwendung beispielsweise in Frage: transparente Gläser wie weiße oder blaue Glasplatte, mit Silikat beschichtete blaue Glasplatte, Kunstharzplatte oderfilme auf Basis von z.B. Polyester-, Polycarbonat-, Acryl-, oder Vinylchloridharz, ferner Metallplatten auf Basis von Aluminium, Kupfer, Nickel, oder Stahl sowie Keramikplatten oder Halbleiterplatten mit aufgebrachten photoelektrischen Transferelementen.

Die Auftragung erfolgt im Allgemeinen so, dass die Schichtdicke der erhaltenen photosensitiven Schicht bei 0,1 bis 10 µm liegt.

Im Anschluss an den Auftrag kann eine thermische Trocknung der Schicht erfolgen.

Die Belichtung erfolgt vorzugsweise, indem die photosensitive Schicht einem aktiven Lichtstrahl vorzugsweise in Form eines Bildmusters mittels Photomaske ausgesetzt wird. Hierdurch wird an

den belichteten Stellen die Schicht gehärtet. Geeignete Lichtquellen sind z.B.: Hochdruck-und Ultrahochdruckquecksilberdampflampe, Xenon-, Metallhalogenid-, Fluoreszenzlampe sowie Laserstrahl im sichtbaren Bereich.

Durch die Entwicklung im Anschluss an die Belichtung wird der unbelichtete Teil der Beschichtung entfernt und man erhält die gewünschte Bildmusterform der Farbelemente. Übliche Entwicklungsmethoden umfassen das Besprühen mit oder Tauchen in wässrige alkalische Entwicklerlösung oder in ein organisches Lösungsmittel, das anorganische Alkali wie z.B. Natrium- oder Kaliumhydroxid, Natriummetasilikat oder organische Basen wie Monoethanolamin, Diethanolamin, Triethanolamin, Triethylamin oder deren Salze enthält.

Nach der Entwicklung erfolgt in der Regel eine thermische Nachtrocknung/-härtung der Bildmuster.

Die erfindungsgemäße Verwendung der Metallazopigmente ist vorzugsweise dadurch gekennzeichnet, dass diese alleine oder in Mischung mit anderen, für die Herstellung von Farbfiltern üblichen, Pigmenten in den Farbfiltern bzw. Pigmentpräparationen oder Zubereitungen für Farbfilter eingesetzt werden.

Diese "anderen Pigmente" können sowohl andere Metallsalze einer Azo-Verbindung der Formel (I) oder darauf basierende Pigmentpräparationen sein als auch andere anorganische oder organische Pigmente.

Hinsichtlich der Auswahl anderer gegebenenfalls mitzuverwendender Pigmente besteht erfindungsgemäß keine Einschränkung. Es kommen sowohl anorganische als auch organische Pigmente in Frage.

Bevorzugte organische Pigmente sind z.B. solche der Monoazo-, Disazo-, verlackte Azo-, ß-Naphthol-, Napthol AS-, Benzimidazolon-, Disazokondensations-, Azometallkomplex-, Isoindolin- und Isoindolinon-Reihe, ferner polycyclische Pigmente wie z.B. aus der Phthalocyanin-, Chinacridon-, Perylen-, Perinon-, Thioindigo-, Anthrachinon-, Dioxazin-, Chinophthalon- und Diketopyrrolopyrrol-Reihe. Außerdem verlackte Farbstoffe wie Ca-, Mg-und AI-Lacke von sulfonsäure- oder carbonsäuregruppenhaltigen Farbstoffen.

Beispiele für gegebenenfalls mitzuverwendende andere organische Pigmente sind:
Colour Index Pigment Yellow 12, 13, 14, 17, 20, 24, 74, 83, 86, 93, 94, 109, 110, 117, 125, 137, 138, 139, 147, 148, 150, 153, 154, 166, 173, 185, oder
Colour Index Pigment Orange 13, 31, 36, 38, 40, 42, 43, 51, 55, 59, 61, 64, 65, 71, 72, 73 oder
Colour Index Pigment Red 9, 97, 122, 123, 144, 149, 166, 168, 177, 180, 192, 215, 216, 224, 254,272,oder
Colour Index Pigment Green 7, 10, 36, 37, 45, 58 oder
Colour Index Pigment Blue 15, 15:1, 15:2, 15:3, 15:4, 15:6, 16 sowie
Colour Index Pigment Violett 19, 23.

Darüber hinaus können auch lösliche organische Farbstoffe in Verbindung mit den erfindungsgemäßen neuen Pigmenten eingesetzt werden.

Sofern "andere Pigmente" zusätzlich eingesetzt werden, beträgt der Anteil an erfindungsgemäßem Metallazopigment vorzugsweise 1-99 Gew.-%, insbesondere 20-80 Gew.-% bezogen auf die eingesetzte Gesamtmenge aller Pigmente. Besonders bevorzugt sind die erfindungsgemäßen Pigmentpräparationen sowie Zubereitungen, enthaltend mindestens ein erfindungsgemäßes Metallazopigment und C.I. Pigment Green 36 und/oder C.I. Pigment Green 58 im Verhältnis von 20 bis 80 Gew.-% Metallazopigment zu 80 bis 20 Gew.-% C.I. Pigment Green 36 und/oder C.I. Pigment Green 58, vorzugsweise von 40 bis 60 Gew.- % zu 60 bis 40 Gew.-%.

Hinsichtlich der Bindemittelharze, die zusammen mit dem "Pigment" oder darauf basierender Pigmentpräparationen in Farbfiltern bzw. in den Zubereitungen zur Herstellung von Farbfiltern z.B. nach der Pigment-Dispersionsmethode, eingesetzt werden können, besteht erfindungsgemäß keine besondere Einschränkung, insbesondere kommen für die Anwendung in Farbfiltern an sich bekannte filmbildende Harze in Frage.

Beispielsweise kommen Bindemittelharze aus der Gruppe der Celluloseharze wie Carboxymethylhydroxyethylcellulose und Hydroxyethylcellulose, Acrylharze, Alkydharze, Melaminharze, Epoxidharze, Polyvinylalkohole, Polyvinylpyrrolidone, Polyamide, Polyamidimine, Polyimide,

Polyimidvorstufen wie solche der Formel (14), offenbart in JP-A 11 217 514 und deren Veresterungsprodukte in Frage.

Als solche sind beispielsweise Umsetzungsprodukte von Tetracarbonsäuredianhydrid mit Diaminen zu nennen.

Als Bindemittelharze kommen auch solche in Frage, die photopolymerisierbare, ungesättigte Bindungen enthalten. Die Bindemittelharze können beispielsweise solche aus der Gruppe der Acrylharze aufgebaut sein. Dabei sind insbesondere Homo- und Copolymere polymerisierbarer Monomere zu nennen wie z.B. (Meth)acrylsäuremethylester, (Meth)acrylsäure-ethylester, (Meth)acrylsäurepropylester, (Meth)acrylsäurebutylester, Styrol und Styrolderivate, ferner Copolymere zwischen carboxylgruppentragenden polymerisierbaren Monomeren wie (Meth)acrylsäure, Itaconsäure, Maleinsäure, Maleinsäureanhydrid, Maleinsäuremonoalkylester, insbesondere mit Alkyl von 1 bis 12 C-Atomen, und polymerisierbare Monomere wie (Meth)acrylsäure, Styrol und Styrolderi-vate, wie z.B. α-Methylstyrol, m- oder p-Methoxystyrol, p-Hydroxystyrol. Als Beispiele seien genannt Umsetzungsprodukte von carboxylgruppenhaltigen polymeren Verbindungen mit Verbindungen, die jeweils einen Oxiranring und eine ethylenisch ungesättigte Verbindung enthalten wie z.B. Glycidyl(meth)acrylat, Acrylglycidylether und Itaconsäuremonoalkylglycidylether usw., ferner Umsetzungsprodukte von carboxylgruppenhaltigen polymeren Verbindungen mit Verbindungen, die jeweils eine Hydroxylgruppe und eine ethylenisch ungesättigte Verbindung (ungesättigte Alkohole) enthalten wie Allylalkohol, 2-Buten-4-ol, Oleylalkohol, 2-Hydroxy-ethyl(meth)acrylat, N-Methylolacrylamid usw.;
weiterhin können derartige Bindemittelharze auch ungesättigte Verbindungen, die freie Isocyanatgruppen besitzen, enthalten.

Im Allgemeinen liegt die Äquivalenz der Ungesättigtheit (Molgewicht Bindemittelharz pro ungesättigte Verbindung) der genannten Bindemittelharze bei 200 bis 3 000, insbesondere 230 bis 1 000, um sowohl eine ausreichende Photopolymerisierbarkeit und Härte des Films zu erreichen. Der Säurewert liegt im Allgemeinen bei 20 bis 300, insbesondere 40 bis 200, um eine genügende Alkali-Entwicklungsfähigkeit nach der Belichtung des Films zu erzielen.

Das mittlere Molgewicht der einzusetzenden Bindemittelharze liegt zwischen 1 500 und 200 000, insbesondere 10 000 bis 50 000 g/mol.

Die bei der erfindungsgemäßen Verwendung der Pigmentpräparationen für Farbfilter eingesetzten organischen Lösungsmittel sind z.B. Ketone, Alkylenglykolether, Alkohole und aromatische Verbindungen. Beispiele aus der Gruppe der Ketone sind: Aceton, Methylethylketon, Cyclohexanon etc.; aus der Gruppe der Alkylenglykolether: Methylcellosolve (Ethylenglykolmonomethylether), Butylcellosolve (Etylenglykolmonobutylether) Methylcellosolveacetat, Ethylcellosolveacetat, Butylcellosolveacetat, Ethylenglykolmonopropylether, Ethylenglykolmonohexylether, Ethylenglykoldimethylether, Diethylenglykolethylether, Diethylenglykoldiethylether, Propylenglykolmonomethylether, Propylenglykolmonoethylether, Propylenglykolmonopropylether, Propylenglykolmonobutylether, Propylenglykol-monomethyletheracetat, Diethylenglykolmethyletheracetat, Diethylenglykolethyletheracetat, Diethylenglykolpropyletheracetat, Diethylenglykolisopropyletheracetat, Diethylenglykolbutyl-etheracetat, Diethylenglykol-t-butyletheracetat, Triethylenglykolmethyletheracetat, Triethylen-glykolethyletheracetat, Triethylenglykolpropyletheracetat, Triethylenglykoliso-propyletheracetat, Triethylenglykolbutyletheracetat, Triethylenglykol-t-butyletheracetat, etc.; aus der Gruppe der Alkohole: Methylalkohol, Ethylalkohol, Isopropylalkohol, n-Butylalkohol, 3-Methyl-3-methoxybutanol, etc.; aus der Gruppe der aromatischen Lösungsmittel Benzol, Toluol, Xylol, N-Methyl-2-Pyrrolidon, N-Hydroxymethyl-2-Essigsäureethylester, etc.

Weitere andere Lösungsmittel sind 1,2-Propandioldiacetat, 3-Methyl-3-methoxybutylacetat, Essigsäureethylester, Tetrahydrofuran, etc. Die Lösungsmittel können einzeln oder in Gemischen untereinander eingesetzt werden.

Die Erfindung betrifft weiterhin einen Photolack, enthaltend wenigstens ein erfindungsgemäßes Metallazopigment oder wenigstens eine erfindungsgemäße Pigmentpräparation und wenigstens ein photohärtbares Monomer sowie wenigstens einen Photoinitiator.

Die photohärtbaren Monomere enthalten im Molekül wenigstens eine reaktive Doppelbindung und gegebenenfalls andere reaktive Gruppen.

Als photohärtbare Monomere seien in diesem Zusammenhang insbesondere reaktive Lösungsmittel bzw. sog. Reaktivverdünner verstanden z.B. aus der Gruppe der mono-, di- , tri- und multifunktionelle Acrylate und Methacrylate, Vinylether, sowie Glycidylether. Als zusätzlich enthaltene reaktive Gruppen kommen in Frage Allyl-, Hydroxy-, Phosphat-, Urethan-, sek. Amin- und N-Alkoxymethylgruppen.

Derartige Monomere sind dem Fachmann bekannt und beispielsweise in *[*Römpp Lexikon, Lacke und Druckfarben, Dr. Ulrich Zorll, Thieme Verlag Stuttgart-New York, 1998, S. 491/492*]* aufgeführt.

Die Auswahl der Monomere richtet sich insbesondere nach der Art und Intensität der verwendeten Strahlenart der Belichtung, der gewünschten Reaktion mit dem Photoinitiator und den Filmeigenschaften. Es können auch Kombinationen von Monomeren eingesetzt werden.

Als Photoreaktionsstarter oder Photoinitiatoren seien Verbindungen verstanden, die infolge der Adsorption sichtbarer oder ultravioletter Strahlung reaktive Zwischenprodukte bilden, die eine Polymerisationsreaktion beispielsweise der oben genannten Monomeren und/oder Bindemittelharze auslösen können. Photoreaktionsstarter sind ebenfalls allgemein bekannt und können ebenfalls aus *[*Römpp Lexikon, Lacke und Druckfarben, Dr. Ulrich Zorll, Thieme Verlag Stuttgart-New York, 1998, S. 445/446*]* entnommen werden.

Erfindungsgemäß besteht keine Einschränkung hinsichtlich der einzusetzenden photohärtbaren Monomeren oder Photoinitiatoren.

Die Erfindung betrifft bevorzugt Photolacke enthaltend
A) wenigstens ein erfindungsgemäßes Metallazopigment, insbesondere in Mischung mit anderen Pigmenten, vorzugsweise C.I. Pigment Green 36 und/oder Pigment Green 58 oder eine darauf basierende erfindungsgemäße Pigmentpräparation,
B1) wenigstens ein photohärtbares Monomer,
B2) wenigstens einen Photoinitiator,
C1) gegebenenfalls ein organisches Lösungsmittel,
D) gegebenenfalls ein Dispergiermittel,
E) gegebenenfalls ein Bindemittelharz,
sowie gegebenenfalls weitere Zusätze.

Erfindungsgemäß besteht auch keine Einschränkung hinsichtlich der Technologie zur Erzeugung der gefärbten Bildelementmuster auf Basis der erfindungsgemäß zu verwendenden Pigmente oder feste Pigmentpräparationen. Neben dem oben beschriebenen photolithographischen Verfahren sind andere Verfahren wie Offset-Druck, chemisches Ätzen oder Ink Jet Druck ebenso geeignet. Die Auswahl der geeigneten Bindemittelharze und Lösungsmittel bzw. Pigment-Trägermedien sowie weitere Zusätze sind auf das jeweilige Verfahren abzustimmen. Beim Ink Jet Verfahren, worunter sowohl der thermische als auch mechanische und piezo-mechanische Ink Jet Druck verstanden werden, kommen neben rein organischen auch wässrig-organische Trägermedien für die Pigmente und gegebenenfalls Bindemittelharze in Frage, wässrig-organische Trägermedien werden sogar bevorzugt.

Die folgenden Beispiele sollen die vorliegende Erfindung erläutern ohne sie jedoch darauf zu beschränken.

### Beispiele

### Herstellung der Vorstufe Azobarbitursäure (Vorschrift 1)

In 3600 g destillierten Wasser von 85°C wurden 154,1 g Diazobarbitursäure und 128,1 g Barbitursäure eingetragen. Anschließend wurde mit wässriger Kalilauge ein pH-Wert von etwa 5 eingestellt und 90 Minuten nachgerührt.

### Beispiel 1: Herstellung von Pigment 1

Eine nach Vorschrift 1 hergestellte Azobarbitursäure wurde bei 82°C mit 5000 g destilliertem Wasser versetzt. Danach wurden 252,2 g Melamin eingetragen. Anschließend wurde eine Mischung aus 0,70 Mol einer ca. 30%igen Nickel(II)chlorid-Lösung, 0,05 Mol einer ca. 30%igen Zink(II)chlorid-Lösung und 0,167 Mol einer ca. 20%igen Lanthan(III)chlorid-Lösung zugetropft. Nach 3 Stunden bei 82°C wurde mit KOH auf einen pH-Wert von ca. 5,5 eingestellt. Danach wurde bei 90°C mit ca. 1000 g destilliertem Wasser verdünnt. Anschließend wurden 113 g 30%ige Salzsäure zugetropft und 12 Stunden bei 90°C getempert. Danach wurde mit wässriger Kalilauge ein pH-Wert von ca. 5 eingestellt. Anschließend wurde das Pigment auf einer Saugnutsche isoliert, gewaschen und bei 80°C im Vakuumtrockenschrank getrocknet und in einer üblichen Labormühle ca. 2 Minuten gemahlen. (= Pigment 1)

### Beispiele 2 bis 126

Zur Herstellung der erfindungsgemäßen Pigmente 2 bis 85 sowie der nicht erfindungsgemäßen Pigmente 86 bis 126 wurde jeweils analog zu Beispiel 1 vorgegangen. Es wurde jeweils eine nach Vorschrift 1 hergestellte Azobarbitursäure bei 82°C mit 5000 g destilliertem Wasser versetzt und danach 252,2 g Melamin eingetragen. Anschließend wurde anstatt der Metallsalzlösung des Beispiels 1 jeweils eine Metallsalzlösung, wie in den folgenden Beispielen angegeben, zugetropft. Die Aufarbeitung und Isolierung, Trocknung und Mahlung des jeweiligen Pigments erfolgte bei allen Beispielen analog zu der in Beispiel 1 angegebenen Vorschrift.

### Beispiel 2: Herstellung von Pigment 2

Es wurde eine Mischung aus 0,50 Mol einer ca. 30%igen Nickel(II)chlorid-Lösung, 0,25 Mol einer ca. 30%igen Zink(II)chlorid-Lösung und 0,167 Mol einer ca. 20%igen Cer(III)chlorid-Lösung zugetropft.

### Beispiel 3: Herstellung von Pigment 3

Es wurde eine Mischung aus 0,30 Mol einer ca. 30%igen Nickel(II)chlorid-Lösung, 0,45 Mol einer ca. 30%igen Zink(II)chlorid-Lösung und 0,167 Mol einer ca. 20%igen Praseodym(III)chlorid-Lösung zugetropft.

### Beispiel 4: Herstellung von Pigment 4

Es wurde eine Mischung aus 0,05 Mol einer ca. 30%igen Nickel(II)chlorid-Lösung, 0,70 Mol einer ca. 30%igen Zink(II)chlorid-Lösung und 0,167 Mol einer ca. 20%igen Neodym(III)chlorid-Lösung zugetropft.

### Beispiel 5: Herstellung von Pigment 5

Es wurde eine Mischung aus 0,70 Mol einer ca. 30%igen Nickel(II)chlorid-Lösung, 0,05 Mol einer ca. 30%igen Zink(II)chlorid-Lösung und 0,167 Mol einer ca. 20%igen Samarium(III)chlorid-Lösung zugetropft.

### Beispiel 6: Herstellung von Pigment 6

Es wurde eine Mischung aus 0,50 Mol einer ca. 30%igen Nickel(II)chlorid-Lösung, 0,25 Mol einer ca. 30%igen Zink(II)chlorid-Lösung und 0,167 Mol einer ca. 20%igen Europium(III)chlorid-Lösung zugetropft.

### Beispiel 7: Herstellung von Pigment 7

Es wurde eine Mischung aus 0,30 Mol einer ca. 30%igen Nickel(II)chlorid-Lösung, 0,45 Mol einer ca. 30%igen Zink(II)chlorid-Lösung und 0,167 Mol einer ca. 20%igen Gadolinium(III)chlorid-Lösung zugetropft.

### Beispiel 8: Herstellung von Pigment 8

Es wurde eine Mischung aus 0,05 Mol einer ca. 30%igen Nickel(II)chlorid-Lösung, 0,70 Mol einer ca. 30%igen Zink(II)chlorid-Lösung und 0,167 Mol einer ca. 20%igen Terbium(III)chlorid-Lösung zugetropft.

### Beispiel 9: Herstellung von Pigment 9

Es wurde eine Mischung aus 0,70 Mol einer ca. 30%igen Nickel(II)chlorid-Lösung, 0,05 Mol einer ca. 30%igen Zink(II)chlorid-Lösung und 0,167 Mol einer ca. 20%igen Dysprosium(III)chlorid-Lösung zugetropft.

### Beispiel 10: Herstellung von Pigment 10

Es wurde eine Mischung aus 0,50 Mol einer ca. 30%igen Nickel(II)chlorid-Lösung, 0,25 Mol einer ca. 30%igen Zink(II)chlorid-Lösung und 0,167 Mol einer ca. 20%igen Holmium(III)chlorid-Lösung zugetropft.

### Beispiel 11: Herstellung von Pigment 11

Es wurde eine Mischung aus 0,30 Mol einer ca. 30%igen Nickel(II)chlorid-Lösung, 0,45 Mol einer ca. 30%igen Zink(II)chlorid-Lösung und 0,167 Mol einer ca. 20%igen Erbium(III)chlorid-Lösung zugetropft.

### Beispiel 12: Herstellung von Pigment 12

Es wurde eine Mischung aus 0,05 Mol einer ca. 30%igen Nickel(II)chlorid-Lösung, 0,70 Mol einer ca. 30%igen Zink(II)chlorid-Lösung und 0,167 Mol einer ca. 20%igen Thulium(III)chlorid-Lösung zugetropft.

### Beispiel 13: Herstellung von Pigment 13

Es wurde eine Mischung aus 0,70 Mol einer ca. 30%igen Nickel(II)chlorid-Lösung, 0,05 Mol einer ca. 30%igen Zink(II)chlorid-Lösung und 0,167 Mol einer ca. 20%igen Ytterbium(III)chlorid-Lösung zugetropft.

### Beispiel 14: Herstellung von Pigment 14

Es wurde eine Mischung aus 0,50 Mol einer ca. 30%igen Nickel(II)chlorid-Lösung, 0,25 Mol einer ca. 30%igen Zink(II)chlorid-Lösung und 0,25 Mol einer ca. 20%igen Strontium(III)chlorid-Lösung zugetropft.

### Beispiel 15: Herstellung von Pigment 15

Es wurde eine Mischung aus 0,30 Mol einer ca. 30%igen Nickel(II)chlorid-Lösung, 0,45 Mol einer ca. 30%igen Zink(II)chlorid-Lösung und 0,25 Mol einer ca. 20%igen Magnesium(III)chlorid-Lösung zugetropft.

### Beispiel 16: Herstellung von Pigment 16

Es wurde eine Mischung aus 0,05 Mol einer ca. 30%igen Nickel(II)chlorid-Lösung, 0,70 Mol einer ca. 30%igen Zink(II)chlorid-Lösung und 0,25 Mol einer ca. 20%igen Calcium(III)chlorid-Lösung zugetropft.

### Beispiel 17: Herstellung von Pigment 17

Es wurde eine Mischung aus 0,70 Mol einer ca. 30%igen Nickel(II)chlorid-Lösung, 0,05 Mol einer ca. 30%igen Zink(II)chlorid-Lösung und 0,25 Mol einer ca. 20%igen Mangan(III)chlorid-Lösung zugetropft.

### Beispiel 18: Herstellung von Pigment 18

Es wurde eine Mischung aus 0,05 Mol einer ca. 30%igen Nickel(II)chlorid-Lösung, 0,80 Mol einer ca. 30%igen Zink(II)chlorid-Lösung und 0,10 Mol einer ca. 20%igen Lanthan(III)chlorid-Lösung zugetropft.

### Beispiel 19: Herstellung von Pigment 19

Es wurde eine Mischung aus 0,35 Mol einer ca. 30%igen Nickel(II)chlorid-Lösung, 0,50 Mol einer ca. 30%igen Zink(II)chlorid-Lösung und 0,10 Mol einer ca. 20%igen Cer(III)chlorid-Lösung zugetropft.

### Beispiel 20: Herstellung von Pigment 20

Es wurde eine Mischung aus 0,50 Mol einer ca. 30%igen Nickel(II)chlorid-Lösung, 0,35 Mol einer ca. 30%igen Zink(II)chlorid-Lösung und 0,10 Mol einer ca. 20%igen Praseodym(III)chlorid-Lösung zugetropft.

### Beispiel 21: Herstellung von Pigment 21

Es wurde eine Mischung aus 0,80 Mol einer ca. 30%igen Nickel(II)chlorid-Lösung, 0,05 Mol einer ca. 30%igen Zink(II)chlorid-Lösung und 0,10 Mol einer ca. 20%igen Neodym(III)chlorid-Lösung zugetropft.

### Beispiel 22: Herstellung von Pigment 22

Es wurde eine Mischung aus 0,05 Mol einer ca. 30%igen Nickel(II)chlorid-Lösung, 0,80 Mol einer ca. 30%igen Zink(II)chlorid-Lösung und 0,10 Mol einer ca. 20%igen Samarium(III)chlorid-Lösung zugetropft.

### Beispiel 23: Herstellung von Pigment 23

Es wurde eine Mischung aus 0,35 Mol einer ca. 30%igen Nickel(II)chlorid-Lösung, 0,50 Mol einer ca. 30%igen Zink(II)chlorid-Lösung und 0,10Mol einer ca. 20%igen Europium(III)chlorid-Lösung zugetropft.

### Beispiel 24: Herstellung von Pigment 24

Es wurde eine Mischung aus 0,50 Mol einer ca. 30%igen Nickel(II)chlorid-Lösung, 0,35Mol einer ca. 30%igen Zink(II)chlorid-Lösung und 0,10Mol einer ca. 20%igen Gadolinium(III)chlorid-Lösung zugetropft.

### Beispiel 25: Herstellung von Pigment 25

Es wurde eine Mischung aus 0,80 Mol einer ca. 30%igen Nickel(II)chlorid-Lösung, 0,05 Mol einer ca. 30%igen Zink(II)chlorid-Lösung und 0,10 Mol einer ca. 20%igen Terbium(III)chlorid-Lösung zugetropft.

### Beispiel 26: Herstellung von Pigment 26

Es wurde eine Mischung aus 0,05 Mol einer ca. 30%igen Nickel(II)chlorid-Lösung, 0,80 Mol einer ca. 30%igen Zink(II)chlorid-Lösung und 0,10 Mol einer ca. 20%igen Dysprosium(III)chlorid-Lösung zugetropft.)

### Beispiel 27: Herstellung von Pigment 27

Es wurde eine Mischung aus 0,35 Mol einer ca. 30%igen Nickel(II)chlorid-Lösung, 0,50 Mol einer ca. 30%igen Zink(II)chlorid-Lösung und 0,10 Mol einer ca. 20%igen Holmium(III)chlorid-Lösung zugetropft.

### Beispiel 28: Herstellung von Pigment 28

Es wurde eine Mischung aus 0,50 Mol einer ca. 30%igen Nickel(II)chlorid-Lösung, 0,35 Mol einer ca. 30%igen Zink(II)chlorid-Lösung und 0,10 Mol einer ca. 20%igen Erbium(III)chlorid-Lösung zugetropft.

### Beispiel 29: Herstellung von Pigment 29

Es wurde eine Mischung aus 0,80 Mol einer ca. 30%igen Nickel(II)chlorid-Lösung, 0,05 Mol einer ca. 30%igen Zink(II)chlorid-Lösung und 0,10 Mol einer ca. 20%igen Thulium(III)chlorid-Lösung zugetropft.

### Beispiel 30: Herstellung von Pigment 30

Es wurde eine Mischung aus 0,05 Mol einer ca. 30%igen Nickel(II)chlorid-Lösung, 0,80 Mol einer ca. 30%igen Zink(II)chlorid-Lösung und 0,10 Mol einer ca. 20%igen Ytterbium(III)chlorid-Lösung zugetropft.

### Beispiel 31: Herstellung von Pigment 31

Es wurde eine Mischung aus 0,35 Mol einer ca. 30%igen Nickel(II)chlorid-Lösung, 0,50 Mol einer ca. 30%igen Zink(II)chlorid-Lösung und 0,15 Mol einer ca. 20%igen Strontium(III)chlorid-Lösung zugetropft.

### Beispiel 32: Herstellung von Pigment 32

Es wurde eine Mischung aus 0,50 Mol einer ca. 30%igen Nickel(II)chlorid-Lösung, 0,35 Mol einer ca. 30%igen Zink(II)chlorid-Lösung und 0,15 Mol einer ca. 20%igen Magnesium(III)chlorid-Lösung zugetropft.

### Beispiel 33: Herstellung von Pigment 33

Es wurde eine Mischung aus 0,80 Mol einer ca. 30%igen Nickel(II)chlorid-Lösung, 0,05 Mol einer ca. 30%igen Zink(II)chlorid-Lösung und 0,15 Mol einer ca. 20%igen Calcium(III)chlorid-Lösung zugetropft.

### Beispiel 34: Herstellung von Pigment 34

Es wurde eine Mischung aus 0,50 Mol einer ca. 30%igen Nickel(II)chlorid-Lösung, 0,35 Mol einer ca. 30%igen Zink(II)chlorid-Lösung und 0,15 Mol einer ca. 20%igen Mangan(III)chlorid-Lösung zugetropft.

### Beispiel 35: Herstellung von Pigment 35

Es wurde eine Mischung aus 0,33 Mol einer ca. 30%igen Nickel(II)chlorid-Lösung, 0,60 Mol einer ca. 30%igen Zink(II)chlorid-Lösung und 0,047 Mol einer ca. 20%igen Lanthan(III)chlorid-Lösung zugetropft.

### Beispiel 36: Herstellung von Pigment 36

Es wurde eine Mischung aus 0,90 Mol einer ca. 30%igen Nickel(II)chlorid-Lösung, 0,03 Mol einer ca. 30%igen Zink(II)chlorid-Lösung und 0,047 Mol einer ca. 20%igen Cer(III)chlorid-Lösung zugetropft.

### Beispiel 37: Herstellung von Pigment 37

Es wurde eine Mischung aus 0,60 Mol einer ca. 30%igen Nickel(II)chlorid-Lösung, 0,33 Mol einer ca. 30%igen Zink(II)chlorid-Lösung und 0,047 Mol einer ca. 20%igen Praseodym(III)chlorid-Lösung zugetropft.

### Beispiel 38: Herstellung von Pigment 38

Es wurde eine Mischung aus 0,33 Mol einer ca. 30%igen Nickel(II)chlorid-Lösung, 0,60 Mol einer ca. 30%igen Zink(II)chlorid-Lösung und 0,047 Mol einer ca. 20%igen Neodym(III)chlorid-Lösung zugetropft.

### Beispiel 39: Herstellung von Pigment 39

Es wurde eine Mischung aus 0,03 Mol einer ca. 30%igen Nickel(II)chlorid-Lösung, 0,90 Mol einer ca. 30%igen Zink(II)chlorid-Lösung und 0,047 Mol einer ca. 20%igen Samarium(III)chlorid-Lösung zugetropft.

### Beispiel 40: Herstellung von Pigment 40

Es wurde eine Mischung aus 0,90 Mol einer ca. 30%igen Nickel(II)chlorid-Lösung, 0,03 Mol einer ca. 30%igen Zink(II)chlorid-Lösung und 0,047 Mol einer ca. 20%igen Europium(III)chlorid-Lösung zugetropft.

### Beispiel 41: Herstellung von Pigment 41

Es wurde eine Mischung aus 0,60 Mol einer ca. 30%igen Nickel(II)chlorid-Lösung, 0,33Mol einer ca. 30%igen Zink(II)chlorid-Lösung und 0,047 Mol einer ca. 20%igen Gadolinium(III)chlorid-Lösung zugetropft.

### Beispiel 42: Herstellung von Pigment 42

Es wurde eine Mischung aus 0,33 Mol einer ca. 30%igen Nickel(II)chlorid-Lösung, 0,60 Mol einer ca. 30%igen Zink(II)chlorid-Lösung und 0,047 Mol einer ca. 20%igen Terbium(III)chlorid-Lösung zugetropft.

### Beispiel 43: Herstellung von Pigment 43

Es wurde eine Mischung aus 0,03 Mol einer ca. 30%igen Nickel(II)chlorid-Lösung, 0,90 Mol einer ca. 30%igen Zink(II)chlorid-Lösung und 0,047 Mol einer ca. 20%igen Dysprosium(III)chlorid-Lösung zugetropft.

### Beispiel 44: Herstellung von Pigment 44

Es wurde eine Mischung aus 0,90 Mol einer ca. 30%igen Nickel(II)chlorid-Lösung, 0,03 Mol einer ca. 30%igen Zink(II)chlorid-Lösung und 0,047 Mol einer ca. 20%igen Holmium(III)chlorid-Lösung zugetropft.

### Beispiel 45: Herstellung von Pigment 45

Es wurde eine Mischung aus 0,60 Mol einer ca. 30%igen Nickel(II)chlorid-Lösung, 0,33 Mol einer ca. 30%igen Zink(II)chlorid-Lösung und 0,047 Mol einer ca. 20%igen Erbium(III)chlorid-Lösung zugetropft.

### Beispiel 46: Herstellung von Pigment 46

Es wurde eine Mischung aus 0,33 Mol einer ca. 30%igen Nickel(II)chlorid-Lösung, 0,60 Mol einer ca. 30%igen Zink(II)chlorid-Lösung und 0,047 Mol einer ca. 20%igen Thulium(III)chlorid-Lösung zugetropft.

### Beispiel 47: Herstellung von Pigment 47

Es wurde eine Mischung aus 0,03 Mol einer ca. 30%igen Nickel(II)chlorid-Lösung, 0,90 Mol einer ca. 30%igen Zink(II)chlorid-Lösung und 0,047 Mol einer ca. 20%igen Ytterbium(III)chlorid-Lösung zugetropft.

### Beispiel 48: Herstellung von Pigment 48

Es wurde eine Mischung aus 0,90 Mol einer ca. 30%igen Nickel(II)chlorid-Lösung, 0,03 Mol einer ca. 30%igen Zink(II)chlorid-Lösung und 0,07 Mol einer ca. 20%igen Strontium(III)chlorid-Lösung zugetropft.

### Beispiel 49: Herstellung von Pigment 49

Es wurde eine Mischung aus 0,60 Mol einer ca. 30%igen Nickel(II)chlorid-Lösung, 0,33 Mol einer ca. 30%igen Zink(II)chlorid-Lösung und 0,07 Mol einer ca. 20%igen Magnesium(III)chlorid-Lösung zugetropft.

### Beispiel 50: Herstellung von Pigment 50

Es wurde eine Mischung aus 0,33 Mol einer ca. 30%igen Nickel(II)chlorid-Lösung, 0,60 Mol einer ca. 30%igen Zink(II)chlorid-Lösung und 0,07 Mol einer ca. 20%igen Calcium(III)chlorid-Lösung zugetropft.

### Beispiel 51: Herstellung von Pigment 51

Es wurde eine Mischung aus 0,03 Mol einer ca. 30%igen Nickel(II)chlorid-Lösung, 0,90 Mol einer ca. 30%igen Zink(II)chlorid-Lösung und 0,07 Mol einer ca. 20%igen Mangan(III)chlorid-Lösung zugetropft.

### Beispiel 52: Herstellung von Pigment 52

Es wurde eine Mischung aus 0,37 Mol einer ca. 30%igen Nickel(II)chlorid-Lösung, 0,60 Mol einer ca. 30%igen Zink(II)chlorid-Lösung und 0,020 Mol einer ca. 20%igen Lanthan(III)chlorid-Lösung zugetropft.

### Beispiel 53: Herstellung von Pigment 53

Es wurde eine Mischung aus 0,05 Mol einer ca. 30%igen Nickel(II)chlorid-Lösung, 0,90 Mol einer ca. 30%igen Zink(II)chlorid-Lösung und 0,020 Mol einer ca. 20%igen Cer(III)chlorid-Lösung zugetropft.

### Beispiel 54: Herstellung von Pigment 54

Es wurde eine Mischung aus 0,92 Mol einer ca. 30%igen Nickel(II)chlorid-Lösung, 0,05 Mol einer ca. 30%igen Zink(II)chlorid-Lösung und 0,020 Mol einer ca. 20%igen Praseodym(III)chlorid-Lösung zugetropft.

### Beispiel 55: Herstellung von Pigment 55

Es wurde eine Mischung aus 0,60 Mol einer ca. 30%igen Nickel(II)chlorid-Lösung, 0,37 Mol einer ca. 30%igen Zink(II)chlorid-Lösung und 0,020 Mol einer ca. 20%igen Neodym(III)chlorid-Lösung zugetropft. 55)

### Beispiel 56: Herstellung von Pigment 56

Es wurde eine Mischung aus 0,37 Mol einer ca. 30%igen Nickel(II)chlorid-Lösung, 0,60 Mol einer ca. 30%igen Zink(II)chlorid-Lösung und 0,020 Mol einer ca. 20%igen Samarium(III)chlorid-Lösung zugetropft.

### Beispiel 57: Herstellung von Pigment 57

Es wurde eine Mischung aus 0,05 Mol einer ca. 30%igen Nickel(II)chlorid-Lösung, 0,92 Mol einer ca. 30%igen Zink(II)chlorid-Lösung und 0,020 Mol einer ca. 20%igen Europium(III)chlorid-Lösung zugetropft.

### Beispiel 58: Herstellung von Pigment 58

Es wurde eine Mischung aus 0,92 Mol einer ca. 30%igen Nickel(II)chlorid-Lösung, 0,05Mol einer ca. 30%igen Zink(II)chlorid-Lösung und 0,020 Mol einer ca. 20%igen Gadolinium(III)chlorid-Lösung zugetropft.

### Beispiel 59: Herstellung von Pigment 59

Es wurde eine Mischung aus 0,60 Mol einer ca. 30%igen Nickel(II)chlorid-Lösung, 0,37 Mol einer ca. 30%igen Zink(II)chlorid-Lösung und 0,020 Mol einer ca. 20%igen Terbium(III)chlorid-Lösung zugetropft.

### Beispiel 60: Herstellung von Pigment 60

Es wurde eine Mischung aus 0,37 Mol einer ca. 30%igen Nickel(II)chlorid-Lösung, 0,60 Mol einer ca. 30%igen Zink(II)chlorid-Lösung und 0,020 Mol einer ca. 20%igen Dysprosium(III)chlorid-Lösung zugetropft:

### Beispiel 61: Herstellung von Pigment 61

Es wurde eine Mischung aus 0,05 Mol einer ca. 30%igen Nickel(II)chlorid-Lösung, 0,92 Mol einer ca. 30%igen Zink(II)chlorid-Lösung und 0,020 Mol einer ca. 20%igen Holmium(III)chlorid-Lösung zugetropft

### Beispiel 62: Herstellung von Pigment 62

Es wurde eine Mischung aus 0,92 Mol einer ca. 30%igen Nickel(II)chlorid-Lösung, 0,05 Mol einer ca. 30%igen Zink(II)chlorid-Lösung und 0,020 Mol einer ca. 20%igen Erbium(III)chlorid-Lösung zugetropft.

### Beispiel 63: Herstellung von Pigment 63

Es wurde eine Mischung aus 0,60 Mol einer ca. 30%igen Nickel(II)chlorid-Lösung, 0,37 Mol einer ca. 30%igen Zink(II)chlorid-Lösung und 0,020 Mol einer ca. 20%igen Thulium(III)chlorid-Lösung zugetropft.

### Beispiel 64: Herstellung von Pigment 64

Es wurde eine Mischung aus 0,37 Mol einer ca. 30%igen Nickel(II)chlorid-Lösung, 0,60 Mol einer ca. 30%igen Zink(II)chlorid-Lösung und 0,020 Mol einer ca. 20%igen Ytterbium(III)chlorid-Lösung zugetropft.

### Beispiel 65: Herstellung von Pigment 65

Es wurde eine Mischung aus 0,05 Mol einer ca. 30%igen Nickel(II)chlorid-Lösung, 0,92 Mol einer ca. 30%igen Zink(II)chlorid-Lösung und 0,030 Mol einer ca. 20%igen Strontium(III)chlorid-Lösung zugetropft.

### Beispiel 66: Herstellung von Pigment 66

Es wurde eine Mischung aus 0,92 Mol einer ca. 30%igen Nickel(II)chlorid-Lösung, 0,05 Mol einer ca. 30%igen Zink(II)chlorid-Lösung und 0,030 Mol einer ca. 20%igen Magnesium(III)chlorid-Lösung zugetropft.

### Beispiel 67: Herstellung von Pigment 67

Es wurde eine Mischung aus 0,60 Mol einer ca. 30%igen Nickel(II)chlorid-Lösung, 0,37 Mol einer ca. 30%igen Zink(II)chlorid-Lösung und 0,030 Mol einer ca. 20%igen Calcium(III)chlorid-Lösung zugetropft.

### Beispiel 68: Herstellung von Pigment 68

Es wurde eine Mischung aus 0,37 Mol einer ca. 30%igen Nickel(II)chlorid-Lösung, 0,60 Mol einer ca. 30%igen Zink(II)chlorid-Lösung und 0,030 Mol einer ca. 20%igen Mangan(III)chlorid-Lösung zugetropft.

### Beispiel 69: Herstellung von Pigment 69

Es wurde eine Mischung aus 0,95 Mol einer ca. 30%igen Nickel(II)chlorid-Lösung, 0,045 Mol einer ca. 30%igen Zink(II)chlorid-Lösung und 0,0033 Mol einer ca. 20%igen Lanthan(III)chlorid-Lösung zugetropft

### Beispiel 70: Herstellung von Pigment 70

Es wurde eine Mischung aus 0,60 Mol einer ca. 30%igen Nickel(II)chlorid-Lösung, 0,395 Mol einer ca. 30%igen Zink(II)chlorid-Lösung und 0,0033 Mol einer ca. 20%igen Cer(III)chlorid-Lösung zugetropft.

### Beispiel 71: Herstellung von Pigment 71

Es wurde eine Mischung aus 0,395 Mol einer ca. 30%igen Nickel(II)chlorid-Lösung, 0,60 Mol einer ca. 30%igen Zink(II)chlorid-Lösung und 0,0033 Mol einer ca. 20%igen Praseodym(III)chlorid-Lösung zugetropft.

### Beispiel 72: Herstellung von Pigment 72

Es wurde eine Mischung aus 0,045 Mol einer ca. 30%igen Nickel(II)chlorid-Lösung, 0,95 Mol einer ca. 30%igen Zink(II)chlorid-Lösung und 0,0033 Mol einer ca. 20%igen Neodym(III)chlorid-Lösung zugetropft.

### Beispiel 73: Herstellung von Pigment 73

Es wurde eine Mischung aus 0,95 Mol einer ca. 30%igen Nickel(II)chlorid-Lösung, 0,045 Mol einer ca. 30%igen Zink(II)chlorid-Lösung und 0,0033 Mol einer ca. 20%igen Samarium(III)chlorid-Lösung zugetropft.

### Beispiel 74: Herstellung von Pigment 74

Es wurde eine Mischung aus 0,60 Mol einer ca. 30%igen Nickel(II)chlorid-Lösung, 0,395 Mol einer ca. 30%igen Zink(II)chlorid-Lösung und 0,0033 Mol einer ca. 20%igen Europium(III)chlorid-Lösung zugetropft.

### Beispiel 75: Herstellung von Pigment 75

Es wurde eine Mischung aus 0,395 Mol einer ca. 30%igen Nickel(II)chlorid-Lösung, 0,60Mol einer ca. 30%igen Zink(II)chlorid-Lösung und 0,0033 Mol einer ca. 20%igen Gadolinium(III)chlorid-Lösung zugetropft.

### Beispiel 76: Herstellung von Pigment 76

Es wurde eine Mischung aus 0,045 Mol einer ca. 30%igen Nickel(II)chlorid-Lösung, 0,95 Mol einer ca. 30%igen Zink(II)chlorid-Lösung und 0,0033 Mol einer ca. 20%igen Terbium(III)chlorid-Lösung zugetropft.

### Beispiel 77: Herstellung von Pigment 77

Es wurde eine Mischung aus 0,95 Mol einer ca. 30%igen Nickel(II)chlorid-Lösung, 0,045 Mol einer ca. 30%igen Zink(II)chlorid-Lösung und 0,0033 Mol einer ca. 20%igen Dysprosium(III)chlorid-Lösung zugetropft.

### Beispiel 78: Herstellung von Pigment 78

Es wurde eine Mischung aus 0,60 Mol einer ca. 30%igen Nickel(II)chlorid-Lösung, 0,395 Mol einer ca. 30%igen Zink(II)chlorid-Lösung und 0,0033 Mol einer ca. 20%igen Holmium(III)chlorid-Lösung zugetropft.

### Beispiel 79: Herstellung von Pigment 79

Es wurde eine Mischung aus 0,395 Mol einer ca. 30%igen Nickel(II)chlorid-Lösung, 0,60 Mol einer ca. 30%igen Zink(II)chlorid-Lösung und 0,0033 Mol einer ca. 20%igen Erbium(III)chlorid-Lösung zugetropft.

### Beispiel 80: Herstellung von Pigment 80

Es wurde eine Mischung aus 0,045 Mol einer ca. 30%igen Nickel(II)chlorid-Lösung, 0,95 Mol einer ca. 30%igen Zink(II)chlorid-Lösung und 0,0033 Mol einer ca. 20%igen Thulium(III)chlorid-Lösung zugetropft.

### Beispiel 81: Herstellung von Pigment 81

Es wurde eine Mischung aus 0,95 Mol einer ca. 30%igen Nickel(II)chlorid-Lösung, 0,045 Mol einer ca. 30%igen Zink(II)chlorid-Lösung und 0,0033 Mol einer ca. 20%igen Ytterbium(III)chlorid-Lösung zugetropft.

### Beispiel 82: Herstellung von Pigment 82

Es wurde eine Mischung aus 0,60 Mol einer ca. 30%igen Nickel(II)chlorid-Lösung, 0,395 Mol einer ca. 30%igen Zink(II)chlorid-Lösung und 0,0050 Mol einer ca. 20%igen Strontium(III)chlorid-Lösung zugetropft.

### Beispiel 83: Herstellung von Pigment 83

Es wurde eine Mischung aus 0,395 Mol einer ca. 30%igen Nickel(II)chlorid-Lösung, 0,60 Mol einer ca. 30%igen Zink(II)chlorid-Lösung und 0,0050 Mol einer ca. 20%igen Magnesium(III)chlorid-Lösung zugetropft.

### Beispiel 84: Herstellung von Pigment 84

Es wurde eine Mischung aus 0,045 Mol einer ca. 30%igen Nickel(II)chlorid-Lösung, 0,94 Mol einer ca. 30%igen Zink(II)chlorid-Lösung und 0,0050 Mol einer ca. 20%igen Calcium(III)chlorid-Lösung zugetropft.

### Beispiel 85: Herstellung von Pigment 85

Es wurde eine Mischung aus 0,395 Mol einer ca. 30%igen Nickel(II)chlorid-Lösung, 0,60 Mol einer ca. 30%igen Zink(II)chlorid-Lösung und 0,0050 Mol einer ca. 20%igen Mangan(III)chlorid-Lösung zugetropft.

### Beispiel 86: Herstellung von Pigment 86 (nicht erfindungsgemäß)

Es wurde eine Mischung aus 0,60 Mol einer ca. 30%igen Nickel(II)chlorid-Lösung, 0,05 Mol einer ca. 30%igen Zink(II)chlorid-Lösung und 0,233 Mol einer ca. 20%igen Lanthan(III)chlorid-Lösung zugetropft.

### Beispiel 87: Herstellung von Pigment 87 (nicht erfindungsgemäß)

Es wurde eine Mischung aus 0,40 Mol einer ca. 30%igen Nickel(II)chlorid-Lösung, 0,25 Mol einer ca. 30%igen Zink(II)chlorid-Lösung und 0,233 Mol einer ca. 20%igen Cer(III)chlorid-Lösung zugetropft.

### Beispiel 88: Herstellung von Pigment 88 (nicht erfindungsgemäß)

Es wurde eine Mischung aus 0,25 Mol einer ca. 30%igen Nickel(II)chlorid-Lösung, 0,40 Mol einer ca. 30%igen Zink(II)chlorid-Lösung und 0,233 Mol einer ca. 20%igen Praseodym(III)chlorid-Lösung zugetropft.

### Beispiel 89: Herstellung von Pigment 89(nicht erfindungsgemäß)

Es wurde eine Mischung aus 0,05 Mol einer ca. 30%igen Nickel(II)chlorid-Lösung, 0,60 Mol einer ca. 30%igen Zink(II)chlorid-Lösung und 0,233 Mol einer ca. 20%igen Neodym(III)chlorid-Lösung zugetropft.

### Beispiel 90: Herstellung von Pigment 90 (nicht erfindungsgemäß)

Es wurde eine Mischung aus 0,60 Mol einer ca. 30%igen Nickel(II)chlorid-Lösung, 0,05 Mol einer ca. 30%igen Zink(II)chlorid-Lösung und 0,233 Mol einer ca. 20%igen Samarium(III)chlorid-Lösung zugetropft.

### Beispiel 91: Herstellung von Pigment 91 (nicht erfindungsgemäß)

Es wurde eine Mischung aus 0,40 Mol einer ca. 30%igen Nickel(II)chlorid-Lösung, 0,25 Mol einer ca. 30%igen Zink(II)chlorid-Lösung und 0,233 Mol einer ca. 20%igen Europium(III)chlorid-Lösung zugetropft.

### Beispiel 92: Herstellung von Pigment 92 (nicht erfindungsgemäß)

Es wurde eine Mischung aus 0,25 Mol einer ca. 30%igen Nickel(II)chlorid-Lösung, 0,40Mol einer ca. 30%igen Zink(II)chlorid-Lösung und 0,233 Mol einer ca. 20%igen Gadolinium(III)chlorid-Lösung zugetropft.

### Beispiel 93: Herstellung von Pigment 93 (nicht erfindungsgemäß)

Es wurde eine Mischung aus 0,05 Mol einer ca. 30%igen Nickel(II)chlorid-Lösung, 0,60 Mol einer ca. 30%igen Zink(II)chlorid-Lösung und 0,233 Mol einer ca. 20%igen Terbium(III)chlorid-Lösung zugetropft.

### Beispiel 94: Herstellung von Pigment 94 (nicht erfindungsgemäß)

Es wurde eine Mischung aus 0,60 Mol einer ca. 30%igen Nickel(II)chlorid-Lösung, 0,05 Mol einer ca. 30%igen Zink(II)chlorid-Lösung und 0,233 Mol einer ca. 20%igen Dysprosium(III)chlorid-Lösung zugetropft.

### Beispiel 95: Herstellung von Pigment 95 (nicht erfindungsgemäß)

Es wurde eine Mischung aus 0,40 Mol einer ca. 30%igen Nickel(II)chlorid-Lösung, 0,25 Mol einer ca. 30%igen Zink(II)chlorid-Lösung und 0,233 Mol einer ca. 20%igen Holmium(III)chlorid-Lösung zugetropft.

### Beispiel 96: Herstellung von Pigment 96 (nicht erfindungsgemäß)

Es wurde eine Mischung aus 0,25 Mol einer ca. 30%igen Nickel(II)chlorid-Lösung, 0,40 Mol einer ca. 30%igen Zink(II)chlorid-Lösung und 0,233 Mol einer ca. 20%igen Erbium(III)chlorid-Lösung zugetropft.

### Beispiel 97: Herstellung von Pigment 97 (nicht erfindungsgemäß)

Es wurde eine Mischung aus 0,05 Mol einer ca. 30%igen Nickel(II)chlorid-Lösung, 0,60 Mol einer ca. 30%igen Zink(II)chlorid-Lösung und 0,233 Mol einer ca. 20%igen Thulium(III)chlorid-Lösung zugetropft.

### Beispiel 98: Herstellung von Pigment 98 (nicht erfindungsgemäß)

Es wurde eine Mischung aus 0,60 Mol einer ca. 30%igen Nickel(II)chlorid-Lösung, 0,05 Mol einer ca. 30%igen Zink(II)chlorid-Lösung und 0,233 Mol einer ca. 20%igen Ytterbium(III)chlorid-Lösung zugetropft.

### Beispiel 99: Herstellung von Pigment 99 (nicht erfindungsgemäß)

Es wurde eine Mischung aus 0,40 Mol einer ca. 30%igen Nickel(II)chlorid-Lösung, 0,25 Mol einer ca. 30%igen Zink(II)chlorid-Lösung und 0,35 Mol einer ca. 20%igen Strontium(III)chlorid-Lösung zugetropft.

### Beispiel 100: Herstellung von Pigment 100 (nicht erfindungsgemäß)

Es wurde eine Mischung aus 0,25 Mol einer ca. 30%igen Nickel(II)chlorid-Lösung, 0,40 Mol einer ca. 30%igen Zink(II)chlorid-Lösung und 0,35 Mol einer ca. 20%igen Magnesium(III)chlorid-Lösung zugetropft.

### Beispiel 101: Herstellung von Pigment 101 (nicht erfindungsgemäß)

Es wurde eine Mischung aus 0,05 Mol einer ca. 30%igen Nickel(II)chlorid-Lösung, 0,60 Mol einer ca. 30%igen Zink(II)chlorid-Lösung und 0,35 Mol einer ca. 20%igen Calcium(III)chlorid-Lösung zugetropft.

### Beispiel 102: Herstellung von Pigment 102 (nicht erfindungsgemäß)

Es wurde eine Mischung aus 0,60 Mol einer ca. 30%igen Nickel(II)chlorid-Lösung, 0,05 Mol einer ca. 30%igen Zink(II)chlorid-Lösung und 0,35 Mol einer ca. 20%igen Mangan(III)chlorid-Lösung zugetropft.

### Beispiel 103: Herstellung von Pigment 103 (nicht erfindungsgemäß)

Es wurde eine Mischung aus 0,933 Mol einer ca. 30%igen Nickel(II)chlorid-Lösung und 0,067 Mol einer ca. 30%igen Zink(II)chlorid-Lösung zugetropft.

### Beispiel 104: Herstellung von Pigment 104 (nicht erfindungsgemäß)

Es wurde eine Mischung aus 0,666 Mol einer ca. 30%igen Nickel(II)chlorid-Lösung und 0,333 Mol einer ca. 30%igen Zink(II)chlorid-Lösung zugetropft.

### Beispiel 105: Herstellung von Pigment 105 (nicht erfindungsgemäß)

Es wurde eine Mischung aus 0,401 Mol einer ca. 30%igen Nickel(II)chlorid-Lösung und 0,599 Mol einer ca. 30%igen Zink(II)chlorid-Lösung zugetropft.

### Beispiel 106: Herstellung von Pigment 106 (nicht erfindungsgemäß)

Es wurde eine Mischung aus 0,065 Mol einer ca. 30%igen Nickel(II)chlorid-Lösung und 0,935 Mol einer ca. 30%igen Zink(II)chlorid-Lösung zugetropft.

### Beispiel 107: Herstellung von Pigment 107 (nicht erfindungsgemäß)

Es wurde eine Mischung aus 0,059 Mol einer ca. 30%igen Nickel(II)chlorid-Lösung und 0,941 Mol einer ca. 30%igen Zink(II)chlorid-Lösung zugetropft.

### Beispiel 108: Herstellung von Pigment 108 (nicht erfindungsgemäß)

Es wurde eine Mischung aus 0,412 Mol einer ca. 30%igen Nickel(II)chlorid-Lösung und 0,588 Mol einer ca. 30%igen Zink(II)chlorid-Lösung zugetropft.

### Beispiel 109: Herstellung von Pigment 109 (nicht erfindungsgemäß)

Es wurde eine Mischung aus 0,588 Mol einer ca. 30%igen Nickel(II)chlorid-Lösung und 0,412 Mol einer ca. 30%igen Zink(II)chlorid-Lösung zugetropft.

### Beispiel 110: Herstellung von Pigment 110 (nicht erfindungsgemäß)

Es wurde eine Mischung aus 0,941 Mol einer ca. 30%igen Nickel(II)chlorid-Lösung und 0,059 Mol einer ca. 30%igen Zink(II)chlorid-Lösung zugetropft.

### Beispiel 111: Herstellung von Pigment 111 (nicht erfindungsgemäß)

Es wurde eine Mischung aus 0,963 Mol einer ca. 30%igen Nickel(II)chlorid-Lösung und 0,032 Mol einer ca. 30%igen Zink(II)chlorid-Lösung zugetropft.

### Beispiel 112: Herstellung von Pigment 112 (nicht erfindungsgemäß)

Es wurde eine Mischung aus 0,644 Mol einer ca. 30%igen Nickel(II)chlorid-Lösung und 0,356 Mol einer ca. 30%igen Zink(II)chlorid-Lösung zugetropft.

### Beispiel 113: Herstellung von Pigment 113 (nicht erfindungsgemäß)

Es wurde eine Mischung aus 0,355 Mol einer ca. 30%igen Nickel(II)chlorid-Lösung und 0,645 Mol einer ca. 30%igen Zink(II)chlorid-Lösung zugetropft.

### Beispiel 114: Herstellung von Pigment 114 (nicht erfindungsgemäß)

Es wurde eine Mischung aus 0,032 Mol einer ca. 30%igen Nickel(II)chlorid-Lösung und 0,968 Mol einer ca. 30%igen Zink(II)chlorid-Lösung zugetropft.

### Beispiel 115: Herstellung von Pigment 115 (nicht erfindungsgemäß)

Es wurde eine Mischung aus 0,051 Mol einer ca. 30%igen Nickel(II)chlorid-Lösung und 0,949 Mol einer ca. 30%igen Zink(II)chlorid-Lösung zugetropft.

### Beispiel 116: Herstellung von Pigment 116 (nicht erfindungsgemäß)

Es wurde eine Mischung aus 0,948 Mol einer ca. 30%igen Nickel(II)chlorid-Lösung und 0,052 Mol einer ca. 30%igen Zink(II)chlorid-Lösung zugetropft.

### Beispiel 117: Herstellung von Pigment 117 (nicht erfindungsgemäß)

Es wurde eine Mischung aus 0,618 Mol einer ca. 30%igen Nickel(II)chlorid-Lösung und 0,382 Mol einer ca. 30%igen Zink(II)chlorid-Lösung zugetropft.

### Beispiel 118: Herstellung von Pigment 118 (nicht erfindungsgemäß)

Es wurde eine Mischung aus 0,383 Mol einer ca. 30%igen Nickel(II)chlorid-Lösung und 0,617 Mol einer ca. 30%igen Zink(II)chlorid-Lösung zugetropft.

### Beispiel 119: Herstellung von Pigment 119 (nicht erfindungsgemäß)

Es wurde eine Mischung aus 0,955 Mol einer ca. 30%igen Nickel(II)chlorid-Lösung und 0,045 Mol einer ca. 30%igen Zink(II)chlorid-Lösung zugetropft.

### Beispiel 120: Herstellung von Pigment 120 (nicht erfindungsgemäß)

Es wurde eine Mischung aus 0,603 Mol einer ca. 30%igen Nickel(II)chlorid-Lösung und 0,397 Mol einer ca. 30%igen Zink(II)chlorid-Lösung zugetropft.

### Beispiel 121: Herstellung von Pigment 121 (nicht erfindungsgemäß)

Es wurde eine Mischung aus 0,398 Mol einer ca. 30%igen Nickel(II)chlorid-Lösung und 0,602 Mol einer ca. 30%igen Zink(II)chlorid-Lösung zugetropft.

### Beispiel 121: Herstellung von Pigment 121 (nicht erfindungsgemäß)

Es wurde eine Mischung aus 0,398 Mol einer ca. 30%igen Nickel(II)chlorid-Lösung und 0,602 Mol einer ca. 30%igen Zink(II)chlorid-Lösung zugetropft.

### Beispiel 122: Herstellung von Pigment 122 (nicht erfindungsgemäß)

Es wurde eine Mischung aus 0,045 Mol einer ca. 30%igen Nickel(II)chlorid-Lösung und 0,955 Mol einer ca. 30%igen Zink(II)chlorid-Lösung zugetropft.

### Beispiel 123: Herstellung von Pigment 123 (nicht erfindungsgemäß)

Es wurde eine Mischung aus 0,923 Mol einer ca. 30%igen Nickel(II)chlorid-Lösung und 0,077 Mol einer ca. 30%igen Zink(II)chlorid-Lösung zugetropft.

### Beispiel 124: Herstellung von Pigment 124 (nicht erfindungsgemäß)

Es wurde eine Mischung aus 0,615 Mol einer ca. 30%igen Nickel(II)chlorid-Lösung und 0,385 Mol einer ca. 30%igen Zink(II)chlorid-Lösung zugetropft.

### Beispiel 125: Herstellung von Pigment 125 (nicht erfindungsgemäß)

Es wurde eine Mischung aus 0,618 Mol einer ca. 30%igen Nickel(II)chlorid-Lösung und 0,382 Mol einer ca. 30%igen Zink(II)chlorid-Lösung zugetropft.

### Beispiel 126: Herstellung von Pigment 126 (nicht erfindungsgemäß,)

Es wurde eine Mischung aus 0,077 Mol einer ca. 30%igen Nickel(II)chlorid-Lösung und 0,923 Mol einer ca. 30%igen Zink(II)chlorid-Lösung zugetropft.

### Bestimmung der Farbstärke in PVC

Die nach den Beispielen 1 bis 126 hergestellten Pigmente 1 bis 126 wurden jeweils einer Bestimmung der Farbstärke nach folgender Methode unterzogen. Die Ergebnisse sind in Tabelle 1 aufgeführt.

Als Prüfmedium wurde ein Weich-PVC-Compound, durch Homogenisierung von 67,5% Vestolit® E7004 (Vestolit GmbH), 29,0% Hexamoll® Dinch (BASF), 2,25% Baerostab UBZ 770 (Baerlocher GmbH) und 1,25% Isocolor Pigmentpaste weiß (ISL-Chemie) mit einem Labordissolver hergestellt.

Auf einem Laborwalzwerk wurden 100 g des PVC -Compounds bei 150°C auf zwei mit 20 min⁻¹ und 18 min⁻¹ rotierenden Walzen von 150 mm Durchmesser gegeben. Zusammen mit 0,10 g Pigment wurde das entstandene Walzfell achtmal durch einen Walzenspalt von 0,10 mm geführt. Dann wurde das gleichmäßig gefärbte Walzfell bei 0,8 mm Walzenspalt abgenommen und glatt auf eine Metallfläche abgelegt. Das abgekühlte Walzfell wurde dann auf zwei unbeheizten mit 26 min⁻¹ und 24 min⁻¹ rotierenden Walzen von 110 mm Durchmesser achtmal durch einen Waltenspalt von 0,2mm gegeben. Zur Glättung der Oberfläche wurde dieses Walzfell nochmals auf die Walzen von 150°C gegeben, bei 0,8 mm abgenommen und auf glatter Fläche abkühlen gelassen. Muster dieses Fells dienten zur Bestimmung der relativen Farbstärke.

Die Berechnung der relativen Farbstärke erfolgte nach Remissionsmessung der Muster vor einem Weißhintergrund mittels Spektralphotometer mit Messgeometrie d/8 unter Normlichtart D65 und 10° Beobachter nach DIN 55986 unter Verwendung der Summe der K/S-Werte über das sichtbare Spektrum (400nm-700nm).

**Tabelle 1:**

| Probe | Status | Molares Ni/Zn Verhältnis | Farbstärke % |
|---|---|---|---|
| **Pigment 1:** | erfindungsgemäß | **14:1** | **114** |
| **Pigment 2:** | erfindungsgemäß | **2:1** | **115** |
| **Pigment 3:** | erfindungsgemäß | **0,67:1** | **114** |
| **Pigment 4:** | erfindungsgemäß | **0,07:1** | **113** |
| **Pigment 5:** | erfindungsgemäß | **14:1** | **115** |
| **Pigment 6:** | erfindungsgemäß | **2:1** | **114** |
| **Pigment 7:** | erfindungsgemäß | **0,67:1** | **113** |
| **Pigment 8:** | erfindungsgemäß | **0,07:1** | **113** |
| **Pigment 9:** | erfindungsgemäß | **14:1** | **115** |
| **Pigment 10:** | erfindungsgemäß | **2:1** | **114** |
| **Pigment 11:** | erfindungsgemäß | **0,67:1** | **113** |
| **Pigment 12:** | erfindungsgemäß | **0,07:1** | **115** |
| **Pigment 13:** | erfindungsgemäß | **14:1** | **112** |
| **Pigment 14:** | erfindungsgemäß | **2:1** | **111** |
| **Pigment 15:** | erfindungsgemäß | **0,67:1** | **115** |
| **Pigment 16:** | erfindungsgemäß | **0,07:1** | **116** |
| **Pigment 17:** | erfindungsgemäß | **14:1** | **115** |
| **Pigment 18:** | erfindungsgemäß | **0,063:1** | **126** |
| **Pigment 19:** | erfindungsgemäß | **0,7:1** | **127** |
| **Pigment 20:** | erfindungsgemäß | **1,43:1** | **128** |
| **Pigment 21:** | erfindungsgemäß | **16:1** | **125** |
| **Pigment 22:** | erfindungsgemäß | **0,063:1** | **125** |
| **Pigment 23:** | erfindungsgemäß | **0,7:1** | **124** |
| **Pigment 24:** | erfindungsgemäß | **1,43:1** | **122** |
| **Pigment 25:** | erfindungsgemäß | **16:1** | **120** |
| **Pigment 26:** | erfindungsgemäß | **0,063:1** | **122** |
| **Pigment 27:** | erfindungsgemäß | **0,7:1** | **125** |
| **Pigment 28:** | erfindungsgemäß | **1,43:1** | **121** |
| **Pigment 29:** | erfindungsgemäß | **16:1** | **124** |
| **Pigment 30:** | erfindungsgemäß | **0,063:1** | **120** |
| **Pigment 31:** | erfindungsgemäß | **0,7:1** | **122** |
| **Pigment 32:** | erfindungsgemäß | **1,43:1** | **123** |
| **Pigment 33:** | erfindungsgemäß | **16:1** | **122** |
| **Pigment 34:** | erfindungsgemäß | **1,43:1** | **121** |
| **Pigment 35:** | erfindungsgemäß | **0,55:1** | **115** |
| **Pigment 36:** | erfindungsgemäß | **30:1** | **114** |
| **Pigment 37:** | erfindungsgemäß | **1,82:1** | **115** |
| **Pigment 38:** | erfindungsgemäß | **0,55:1** | **115** |
| **Pigment 39:** | erfindungsgemäß | **0,033:1** | **114** |
| **Pigment 40:** | erfindungsgemäß | **30:1** | **111** |
| **Pigment 41:** | erfindungsgemäß | **1,82:1** | **115** |
| **Pigment 42:** | erfindungsgemäß | **0,55:1** | **116** |
| **Pigment 43:** | erfindungsgemäß | **0,033:1** | **117** |
| **Pigment 44:** | erfindungsgemäß | **30:1** | **115** |
| **Pigment 45:** | erfindungsgemäß | **1,82:1** | **113** |
| **Pigment 46:** | erfindungsgemäß | **0,55:1** | **114** |
| **Pigment 47:** | erfindungsgemäß | **0,033:1** | **116** |
| **Pigment 48:** | erfindungsgemäß | **30:1** | **112** |
| **Pigment 49:** | erfindungsgemäß | **1,82:1** | **111** |
| **Pigment 50:** | erfindungsgemäß | **0,55:1** | **113** |
| **Pigment 51:** | erfindungsgemäß | **0,033:1** | **112** |
| **Pigment 52:** | erfindungsgemäß | **0,62:1** | **109** |
| **Pigment 53:** | erfindungsgemäß | **0,054:1** | **108** |
| **Pigment 54:** | erfindungsgemäß | **18,4:1** | **107** |
| **Pigment 55:** | erfindungsgemäß | **1,62:1** | **108** |
| **Pigment 56:** | erfindungsgemäß | **0,62:1** | **109** |
| **Pigment 57:** | erfindungsgemäß | **0,054:1** | **108** |
| **Pigment 58:** | erfindungsgemäß | **18,4:1** | **107** |
| **Pigment 59:** | erfindungsgemäß | **1,62:1** | **109** |
| **Pigment 60:** | erfindungsgemäß | **0,62:1** | **108** |
| **Pigment 61:** | erfindungsgemäß | **0,054:1** | **110** |
| **Pigment 62:** | erfindungsgemäß | **18,4:1** | **109** |
| **Pigment 63:** | erfindungsgemäß | **1,62:1** | **108** |
| **Pigment 64:** | erfindungsgemäß | **0,62:1** | **107** |
| **Pigment 65:** | erfindungsgemäß | **0,054:1** | **109** |
| **Pigment 66:** | erfindungsgemäß | **18,4:1** | **107** |
| **Pigment 67:** | erfindungsgemäß | **1,62:1** | **108** |
| **Pigment 68:** | erfindungsgemäß | **0,62:1** | **107** |
| **Pigment 69:** | erfindungsgemäß | **21.1:1** | **106** |
| **Pigment 70:** | erfindungsgemäß | **1,52.1** | **105** |
| **Pigment 71:** | erfindungsgemäß | **0,66:1** | **104** |
| **Pigment 72:** | erfindungsgemäß | **0,047:1** | **103** |
| **Pigment 73:** | erfindungsgemäß | **21.1:1** | **104** |
| **Pigment 74:** | erfindungsgemäß | **1,52.1** | **105** |
| **Pigment 75:** | erfindungsgemäß | **0,66:1** | **105** |
| **Pigment 76:** | erfindungsgemäß | **0,047:1** | **105** |
| **Pigment 77:** | erfindungsgemäß | **21.1:1** | **104** |
| **Pigment 78:** | erfindungsgemäß | **1,52.1** | **102** |
| **Pigment 79:** | erfindungsgemäß | **0,66:1** | **103** |
| **Pigment 80:** | erfindungsgemäß | **0,047:1** | **106** |
| **Pigment 81:** | erfindungsgemäß | **21.1:1** | **105** |
| **Pigment 82:** | erfindungsgemäß | **1,52.1** | **103** |
| **Pigment 83:** | erfindungsgemäß | **0,66:1** | **105** |
| **Pigment 84:** | erfindungsgemäß | **0,047:1** | **103** |
| **Pigment 85:** | erfindungsgemäß | **0,66:1** | **105** |
| **Pigment 86:** | nicht erfindungsgemäß | **12:1** | **99** |
| **Pigment 87:** | nicht erfindungsgemäß | **1,6:1** | **98** |
| **Pigment 88:** | nicht erfindungsgemäß | **0,63:1** | **97** |
| **Pigment 89:** | nicht erfindungsgemäß | **0,083:1** | **99** |
| **Pigment 90:** | nicht erfindungsgemäß | **12:1** | **95** |
| **Pigment 91:** | nicht erfindungsgemäß | **1,6:1** | **94** |
| **Pigment 92:** | nicht erfindungsgemäß | **0,63:1** | **98** |
| **Pigment 93:** | nicht erfindungsgemäß | **0,083:1** | **99** |
| **Pigment 94:** | nicht erfindungsgemäß | **12:1** | **97** |
| **Pigment 95:** | nicht erfindungsgemäß | **1,6:1** | **96** |
| **Pigment 96:** | nicht erfindungsgemäß | **0,63:1** | **95** |
| **Pigment 97:** | nicht erfindungsgemäß | **0,083:1** | **98** |
| **Pigment 98:** | nicht erfindungsgemäß | **12:1** | **99** |
| **Pigment 99:** | nicht erfindungsgemäß | **1,6:1** | **96** |
| **Pigment 100:** | nicht erfindungsgemäß | **0,63:1** | **97** |
| **Pigment 101:** | nicht erfindungsgemäß | **0,083:1** | **98** |
| **Pigment 102:** | nicht erfindungsgemäß | **12:1** | **96** |
| **Pigment 103:** | nicht erfindungsgemäß | **14.1** | **100** |
| **Pigment 104:** | nicht erfindungsgemäß | **2:1** | **100** |
| **Pigment 105:** | nicht erfindungsgemäß | **0,67:1** | **100** |
| **Pigment 106:** | nicht erfindungsgemäß | **0,07.1** | **100** |
| **Pigment 107:** | nicht erfindungsgemäß | **0,063:1** | **100** |
| **Pigment 108:** | nicht erfindungsgemäß | **0,7:1** | **100** |
| **Pigment 109:** | nicht erfindungsgemäß | **1,43:1** | **100** |
| **Pigment 110:** | nicht erfindungsgemäß | **16:1** | **100** |
| **Pigment 111:** | nicht erfindungsgemäß | **30:1** | **100** |
| **Pigment 112:** | nicht erfindungsgemäß | **1,82:1** | **100** |
| **Pigment 113:** | nicht erfindungsgemäß | **0,55:1** | **100** |
| **Pigment 114:** | nicht erfindungsgemäß | **0,033:1** | **100** |
| **Pigment 115:** | nicht erfindungsgemäß | **0,054:1** | **100** |
| **Pigment 116:** | nicht erfindungsgemäß | **18,4:1** | **100** |
| **Pigment 117:** | nicht erfindungsgemäß | **1,62:1** | **100** |
| **Pigment 118:** | nicht erfindungsgemäß | **0,62:1** | **100** |
| **Pigment 119:** | nicht erfindungsgemäß | **21:1** | **100** |
| **Pigment 120:** | nicht erfindungsgemäß | **1,52:1** | **100** |
| **Pigment 121:** | nicht erfindungsgemäß | **0,66:1** | **100** |
| **Pigment 122:** | nicht erfindungsgemäß | **0,047:1** | **100** |
| **Pigment 123:** | nicht erfindungsgemäß | **12:1** | **100** |
| **Pigment 124:** | nicht erfindungsgemäß | **1,6:1** | **100** |
| **Pigment 125:** | nicht erfindungsgemäß | **0,63:1** | **100** |
| **Pigment 126:** | nicht erfindungsgemäß | **0,083:1** | **100** |

Fazit: Aus Tabelle 1 ist ersichtlich, dass alle erfindungsgemäßen Pigmente erhöhte Farbstärken aufweisen im Vergleich zu den nicht erfindungsgemäßen Pigmenten, die zwar dasselbe molare Ni/Zn-Verhältnis aufweisen wie die erfindungsgemäßen Pigmente, die aber ausschließlich binäre Mischungen darstellen. Dies bedeutet, dass die erfindungsgemäßen Pigmente bezogen auf gleiche Einwaagen höhere optischen Dichten erreichen als die nicht erfindungsgemäßen Pigmente.

## Patentansprüche

1. Metallazopigmente, **dadurch gekennzeichnet, dass** sie enthalten die Komponenten
a) mindestens zwei Metallazoverbindungen die sich mindestens in der Art des Metalls voneinander unterscheiden und die die jeweils
• Struktureinheiten der Formel (I), oder deren tautomeren Formen, 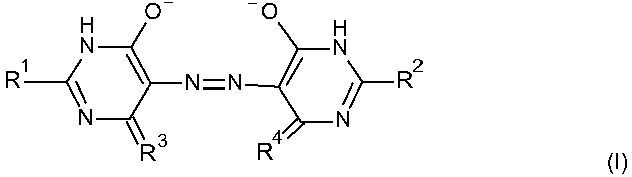 worin
R¹ und R² unabhängig voneinander für OH, NH₂ oder NHR⁵ stehen,
R³ und R⁴ unabhängig voneinander für =O oder =NR⁵ stehen,
R⁵ für Wasserstoff oder Alkyl, vorzugsweise C₁-C₄-Alkyl, steht,
und
• Ni²⁺- beziehungsweise Zn²⁺-Ionen und mindestens ein weiteres Metallion Me enthalten,
wobei
Me für ein 2- oder 3- wertiges Metallion ausgewählt aus der Reihe La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Er³⁺, Tm³⁺ , Yb²⁺, Yb³⁺ , Mg²⁺, Ca²⁺, Sr²⁺, Ba²⁺, Sc³⁺, Y³⁺, Ti²⁺, Ti³⁺, Zr²⁺, Zr³⁺, V²⁺, V³⁺, Nb³⁺, Cr³⁺, Mo²⁺, Mo³⁺, Mn²⁺, Cd²⁺ und Pb²⁺ steht,
mit der Maßgabe, dass die Menge an Zn²⁺-und Ni²⁺-Ionen zusammen 75 bis 99,5 Mol-% beträgt und die Menge an Metallionen Me 25 bis 0,5 Mol-% beträgt, jeweils bezogen auf ein Mol aller Metallionen im Metallazopigment
und
wobei das Molverhältnis von Zn²⁺- zu Ni²⁺- Ionen im Metallazopigment 90 : 3 bis 3 : 90, bevorzugt 80 : 5 bis 5 : 80 und besonders bevorzugt 60 : 33 bis 33 : 60 beträgt,
und
b) mindestens eine Verbindung der Formel (II) 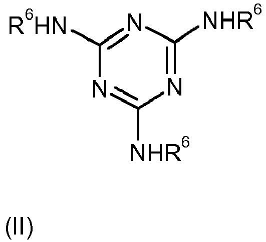 worin
R⁶ für Wasserstoff oder Alkyl, vorzugsweise C₁-C₄-Alkyl das gegebenenfalls ein- oder mehrfach durch OH substituiert ist,
steht.

2. Metallazopigmente gemäß Anspruch 1, **dadurch gekennzeichnet, dass** die Komponenten a) und die Komponenten b) gemeinsam in Form von Addukten vorliegen.

3. Metallazopigmente gemäß Anspruch 1 oder 2, **dadurch gekennzeichnet, dass** in Formel (I)
R¹ und R² für OH stehen,
und
R³ und R⁴ für =O stehen,
und in Formel (II)
R⁶ für Wasserstoff steht.

4. Metallazopigmente gemäß wenigstens einem der Ansprüche 1 bis 3, **dadurch gekennzeichnet, dass** Me für ein 2- oder 3- wertiges Metallion ausgewählt aus der Reihe La³⁺, Ce³⁺, Pr³⁺, Nd³⁺, Sm³⁺, Eu³⁺, Gd³⁺, Tb³⁺, Dy³⁺, Ho³⁺, Er³⁺ , Tm³⁺ und Yb³⁺, Mg²⁺, Ca²⁺, Sr²⁺, Y³⁺ und Mn²⁺, und besonders bevorzugt aus der Reihe La³⁺, Ce³⁺, Pr³⁺, Nd³⁺, Sm³⁺, Tb³⁺, Ho³⁺ und Sr²⁺ steht.

5. Metallazopigmente gemäß wenigstens einem der Ansprüche 1 bis 4, **dadurch gekennzeichnet, dass** pro Mol an Struktureinheiten der Formel (I) 0,05 bis 4 Mol, bevorzugt 0,5 bis 2,5 Mol und ganz besonders bevorzugt 1,0 bis 2,0 Mol an Verbindung der Formel (II) enthalten ist.

6. Metallazopigmente gemäß wenigstens einem der Ansprüche 1 bis 5, **dadurch gekennzeichnet, dass** sie eine spezifische Oberfläche von 50 bis 200 m²/g, bevorzugt von 80 bis 160 m²/g und ganz besonders bevorzugt von 100 bis 150 m²/g besitzen.

7. Verfahren zur Herstellung von Metallazopigmenten gemäß wenigstens einem der Ansprüche 1 bis 6, **dadurch gekennzeichnet dass** eine Verbindung der Formel (III), oder deren Tautomere, 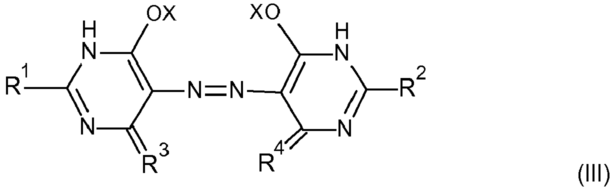 worin
X für ein Alkalimetallion, vorzugsweise für ein Natrium- oder Kaliumion steht,
R¹ und R² unabhängig voneinander für OH, NH₂ oder NHR⁵ stehen,
R³ und R⁴ unabhängig voneinander für =O oder =NR⁵ stehen,
und
R⁵ für Wasserstoff oder Alkyl, vorzugsweise C₁-C₄-Alkyl, steht,
in Gegenwart von mindestens einer Verbindung der Formel (II) 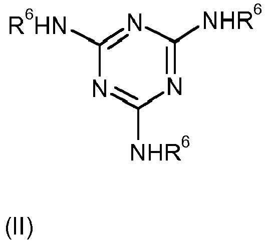 worin
R⁶ für Wasserstoff oder Alkyl, vorzugsweise C₁-C₄-Alkyl das gegebenenfalls ein- oder mehrfach durch OH substituiert ist, steht,
gleichzeitig oder nacheinander mit mindestens einem Nickelsalz und mindestens einem Zinksalz und mit mindestens einem weiteren Metallsalz aus der Reihe der La³⁺-, Ce³⁺-, Pr³⁺-, Nd²⁺-, Nd³⁺-, Sm²⁺-, Sm³⁺-, Eu²⁺-, Eu³⁺-, Gd³⁺-, Tb³⁺-, Dy³⁺-, Ho³⁺-, Er³⁺-, Tm³⁺-, Yb²⁺-, Yb³⁺-, Mg²⁺-, Ca²⁺-, Sr²⁺-, Ba²⁺-, Sc³⁺-, Y³⁺-, Ti²⁺-, Ti³⁺-, Zr²⁺-, Zr³⁺-, V²⁺-, V³⁺-, Nb³⁺-, Cr³⁺-, Mo²⁺-, Mo³⁺-, Mn²⁺-, Cd²⁺- und Pb²⁺-Salze, bevorzugt aus der Reihe der La³⁺-, Ce³⁺-, Pr³⁺-, Nd³⁺-, Sm³⁺-, Eu³⁺-, Gd³⁺-, Tb³⁺-, Dy³⁺-, Ho³⁺-, Er³⁺-, Tm³⁺-, Yb³⁺-, Mg²⁺-, Ca²⁺-, Sr²⁺-, Y³⁺- und Mn²⁺-Salze und besonders bevorzugt aus der Reihe der La³⁺-, Ce³⁺-, Pr³⁺-, Nd³⁺-, Sm³⁺-, Tb³⁺-, Ho³⁺- und Sr²⁺-Salze umsetzt, wobei pro Mol an Verbindung der Formel (III) 0,03 bis 0,95 Mol mindestens eines Nickelsalzes, 0,03 bis 0,95 Mol mindestens eines Zinksalzes und 0,005 bis 0,25 Mol mindestens eines Metallsalzes aus der oben genannten Reihe eingesetzt werden, und die Summe der Molmenge aller eingesetzten Metallsalze 100 Mol-% beträgt.

8. Pigmentpräparationen enthaltend wenigstens ein Metallazopigment gemäß wenigstens einem der Ansprüche 1 bis 6 und wenigstens einen Hilfs- und/oder Zusatzstoff, vorzugsweise aus der Reihe der oberflächenaktiven Mittel, der Oberflächenbelegungsmittel, der Basen und der Lösungsmittel, und gegebenenfalls wenigstens ein weiteres Pigment.

9. Pigmentpräparation gemäß Anspruch 8, **dadurch gekennzeichnet, dass** sie als weiteres Pigment C.I. Pigment Green 36 und/oder C.I. Pigment Green 58 enthält.

10. Verfahren zur Herstellung einer Pigmentpräparation nach wenigstens einem der Ansprüche 8 bis 9, **dadurch gekennzeichnet, dass** wenigstens ein Metallazopigment gemäß wenigstens einem der Ansprüche 1 bis 6 mit wenigstens einem Hilfs- und/ oder Zusatzstoff, vorzugsweise aus der Reihe der oberflächenaktiven Mittel, der Oberflächenbelegungsmittel, der Basen und der Lösungsmittel, und gegebenenfalls mit wenigstens einem weiteren Pigment vermischt oder vermahlen wird.

11. Verwendung eines Metallazopigments gemäß wenigstens einem der Ansprüche 1 bis 6 zur Herstellung von Pigmentpräparationen.

12. Verwendung eines Metallazopigments gemäß wenigstens einem der Ansprüche 1 bis 6 oder einer Pigmentpräparation gemäß wenigstens einem der Ansprüche 8 bis 9 zur Einfärbung von Ink Jet Tinten, Farbfiltern für Flüssigkristallanzeigen, Druckfarben, Leimfarben oder Binderfarben, für die Massefärbung von synthetischen, halbsynthetischen oder natürlichen makromolekularen Stoffen, insbesondere Polyvinylchlorid, Polystyrol, Polyamid, Polyethylen oder Polypropylen, sowie für die Spinnfärbung von natürlichen, regenerierten oder künstlichen Fasern, wie z.B. Cellulose-, Polyester-, Polycarbonat-, Polyacrylnitril- oder Polyamidfasern, sowie zum Bedrucken von Textilien und Papier.

13. Farbfilter, Photolack, Drucktinte oder Flüssigkristallanzeige enthaltend wenigstens ein Metallazopigment gemäß wenigstens einem der Ansprüche 1 bis 6 oder eine Pigmentpräparation gemäß wenigstens einem der Ansprüche 8 bis 9.

14. Photolack enthaltend wenigstens ein Metallazopigment gemäß wenigstens einem der Ansprüche 1 bis 6, oder eine Pigmentpräparation gemäß wenigstens einem der Ansprüche 8 bis 9, und ein oder mehrere photohärtbare Monomere und ein oder mehrere Photoreaktionsstarter und gegebenenfalls ein oder mehrere Binde- oder Dispergiermittel und/oder Lösungsmittel.

15. Verfahren zur Herstellung von Farbfiltern für Flüssigkristallanzeigen umfassend die Schritte a) Auftragen eines Photolacks gemäß Anspruch 14 auf ein Substrat, b) Belichtung mittels Photomaske, c) Härtung und d) Entwicklung zum fertigen farbigen Farbfilter.
